# EUROPEAN PATENT APPLICATION

(11) **EP 2 325 919 A2**
(43) Date of publication of application: **25.05.2011**
(21) Application number: 10251871.9
(22) Date of filing: 29.10.2010
(51) Int. Cl.: H01M 2/10, H01M 2/20, H01M 10/48, B60L 11/18, G01R 31/36, H02J 7/00

(54) **Battery system and electric vehicle including the same**

(30) Priority: 30.10.2009 JP 2009251146; 28.12.2009 JP 2009297760; 08.10.2010 JP 2010229098; 08.10.2010 JP 2010229097
(71) Applicant: Sanyo Electric Co., Ltd., Osaka 570-8677 (JP)
(72) Inventor: Seo, Kazuhiro, Moriguchi City Osaka 570-8677 (JP); Kishimoto, Keiji, Moriguchi City Osaka 570-8677 (JP); Ohkura, Kazumi, Moriguchi City Osaka 570-8677 (JP); Nishihara, Yoshitomo, Moriguchi City Osaka 570-8677 (JP)
(74) Representative: Calderbank, Thomas Roger

(57) **Abstract**

A battery system includes a plurality of battery cells and a plurality of printed circuit boards. A cell characteristics detecting circuit having a cell characteristics detecting function for detecting cell characteristics of the plurality of battery cells is mounted on each of the printed circuit boards. As well as the cell characteristics detecting circuit, a control-related circuit having a function different from the cell characteristics detecting function of each battery cell is mounted on the printed circuit board.

## Description

The present invention relates to a battery system including battery cells and an electric vehicle including the same.

In a battery system used as a driving source of a movable object such as an electric automobile, a plurality of chargeable and dischargeable battery modules are provided for supplying a driving force. Each of the battery modules has such a configuration that a plurality of batteries (battery cells) are connected in series, for example.

JP 8-162171 A discloses a monitoring device of a battery pack mounted on a movable object such as an electric automobile. The battery pack is composed of a plurality of modules, each of which includes a plurality of cells. The monitoring device includes a plurality of voltage measuring units connected to the plurality of modules, respectively, and an electronic control unit (ECU). The ECU is connected to the plurality of voltage measuring units. A voltage of the module detected by each voltage measuring unit is transmitted to the ECU.

JP 2009-168720 A discloses a battery system including a capacitor unit, a contactor and a management unit (MGU). The capacitor unit includes a plurality of cells connected in series and a plurality of controlling units. Each controlling unit includes a state detector that detects a voltage of each cell and so on. The plurality of controlling units are connected to the MGU.

ln the monitoring device of the battery pack described in JP 8-162171 A, the ECU performs various types of monitoring and control such as charge control and life determination of the battery pack.

In the battery system described in JP 2009-168720 A, the MGU performs monitoring and control of the capacitor unit.

The system using the battery pack and monitoring device of JP 8-162171 A and the battery system of JP 2009-168720 A, however, may result in complicated wiring and difficulty in being reduced in size.

An object of the present invention is to provide a battery system whose wiring can be simplified and size can be reduced, and an electric vehicle including the same.
(1) According to one aspect of the present invention, a battery system includes a plurality of battery cells and one or a plurality of circuit boards, wherein each of the one or plurality of circuit boards has a first function of detecting a first parameter of each battery cell, and at least one circuit board further has a second function that is different from the first function.

In the battery system, each of the one or plurality of circuit boards has the first function of detecting the first parameter of each battery cell. The at least one circuit board further has the second function that is different from the first function.

In this case, wiring between a circuit that implements the first function and a circuit that implements the second function is formed on the at least one circuit board. A circuit unit having the second function need not be separately provided in the battery system. This allows wiring of the battery system to be simplified and allows the battery system to be reduced in size.
(2) The second function may include a function of detecting a second parameter of the plurality of battery cells. In this case, since the second parameter of the plurality of battery cells is detected by the second function, a detecting unit that detects the second parameter of the plurality of battery cells need not be separately provided in the battery system. This allows the wiring of the battery system to be further simplified and allows the battery system to be reduced in size.
(3) The second function may include a function of performing control related to the plurality of battery cells. In this case, since the control related to the plurality of battery cells is performed by the second function, a controlling unit that performs the control related to the plurality of battery cells need not be separately provided in the battery system. This allows the wiring of the battery system to be further simplified and allows the battery system to be reduced in size.
(4) The second function may include a function of supplying electric power to a portion, which implements the first function, of the one or plurality of circuit boards. In this case, since the second function causes the electric power to be supplied to the portion, which implements the first function, of the one or plurality of circuit boards, a power supplying unit need not be provided in each of the one or plurality of circuit boards. This allows the wiring of the battery system to be further simplified and allows the battery system to be reduced in size.
(5) Each of the plurality of circuit boards may further include a discharging circuit arranged to cause each battery cell to discharge.

In this case, the discharging circuits are distributed in the plurality of circuit boards. This allows heat generated during discharge of each battery cell to be efficiently released. As a result, circuits, which implement the first and second functions, provided in the plurality of circuit boards can be prevented from being deteriorated.
(6) According to another aspect of the present invention, an electric vehicle includes the battery system according to the one aspect of the present invention, a motor driven by electric power supplied from the plurality of battery cells of the battery system, and a drive wheel rotated by a torque generated by the motor.

In the electric vehicle, the motor is driven by the electric power supplied from the plurality of battery cells. The drive wheel is rotated by the torque generated by the motor, thereby moving the electric vehicle.

The battery system according to the one aspect of the present invention is used in the electric vehicle, thus allowing wiring in the electric vehicle to be simplified and allowing the electric vehicle to be reduced in size.

According to the present embodiment, the wiring of the battery system can be simplified and the battery system can be reduced in size.

Other features, elements, characteristics, and advantages of the present invention will become more apparent from the following description of preferred embodiments of the present invention with reference to the attached drawings.

In the drawings
Fig. 1 is a block diagram showing the configuration of a battery system according to a first invention;
Fig. 2 is a block diagram showing the configurations of printed circuit boards;
Fig. 3 is a block diagram showing the configuration of a cell characteristics detecting circuit;
Fig. 4 is an external perspective view of a battery module;
Fig. 5 is a plan view of the battery module;
Fig. 6 is an end view of the battery module;
Fig. 7 is an external perspective view of bus bars;
Fig. 8 is an external perspective view of FPC boards to which a plurality of bus bars and a plurality of PTC elements are attached;
Fig. 9 is a schematic plan view for explaining connection between the bus bars and a voltage detecting circuit;
Fig. 10 is a schematic plan view showing one example of the configuration of the printed circuit board;
Fig. 11 is a schematic plan view showing one example of the configuration of the printed circuit board;
Fig. 12 is a schematic plan view showing one example of connection and wiring among the battery modules;
Fig. 13 is a block diagram showing the configuration of a battery system according to a second embodiment;
Fig. 14 is a block diagram showing the configurations of printed circuit boards in the second embodiment;
Fig. 15 is a block diagram showing the configurations of printed circuit boards in a third embodiment;
Fig. 16 is a block diagram showing the configurations of printed circuit boards in a fourth embodiment;
Fig. 17 is an enlarged plan view showing a voltage/current bus bar and the FPC board in the battery module;
Fig. 18 is a block diagram showing the configurations of printed circuit boards in a fifth embodiment;
Fig. 19 is a block diagram showing the configurations of printed circuit boards in a sixth embodiment;
Fig. 20 is a block diagram showing the configurations of printed circuit boards in a seventh embodiment;
Fig. 21 is a block diagram showing the configurations of printed circuit boards in an eighth embodiment;
Fig. 22 is a schematic plan view showing one example of connection and wiring among battery modules in a battery system according to a ninth embodiment; and
Fig. 23 is a block diagram showing the configuration of an electric automobile including the battery system.

### [1] First Embodiment

Hereinafter, description will be made of a battery system according to a first embodiment while referring to the drawings. The battery system according to the present embodiment is mounted on an electric vehicle (an electric automobile, for example) using electric power as a driving source.

### (1) Configuration of the Battery System

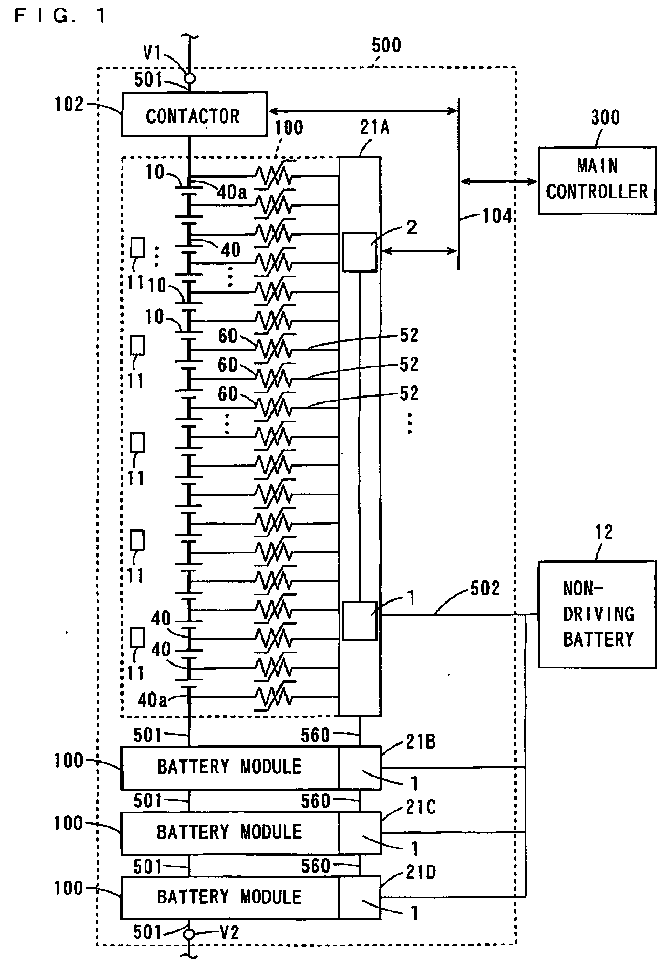

Fig. 1 is a block diagram showing the configuration of the battery system according to the first embodiment. As shown in Fig. 1, the battery system 500 includes a plurality of battery modules 100, a plurality of rigid printed circuit boards (hereinafter abbreviated as printed circuit boards) 21A, 21B, 21C, 21D and a contactor 102. The plurality of printed circuit boards 21A to 21D are provided corresponding to the plurality of battery modules 100, respectively. In the example of Fig. 1, the four printed circuit boards 21A to 21D are provided corresponding to the four battery modules 100 in the battery system 500.

The plurality of battery modules 100 are connected to one another through power supply lines 501. Each battery module 100 includes a plurality of (eighteen in this example) battery cells 10 and a plurality of (five in this example) thermistors 11. That is, the battery system 500 of Fig. 1 includes seventy two battery cells 10 in total.

In each battery module 100, the plurality of battery cells 10 are integrally arranged adjacent to one another, and are connected in series through a plurality of bus bars 40. Each battery cell 10 is a secondary battery such as a lithium-ion battery or a nickel metal hydride battery.

The battery cells 10 arranged at both ends of the battery module 100 are connected to the power supply lines 501 through bus bars 40a, respectively. In this manner, all the battery cells 10 of the plurality of battery modules 100 are connected in series in the battery system 500. The power supply lines 501 pulled out from the battery system 500 are connected to a load such as a motor of the electric vehicle through voltage terminals V1, V2. Details of the battery modules 100 will be described below.

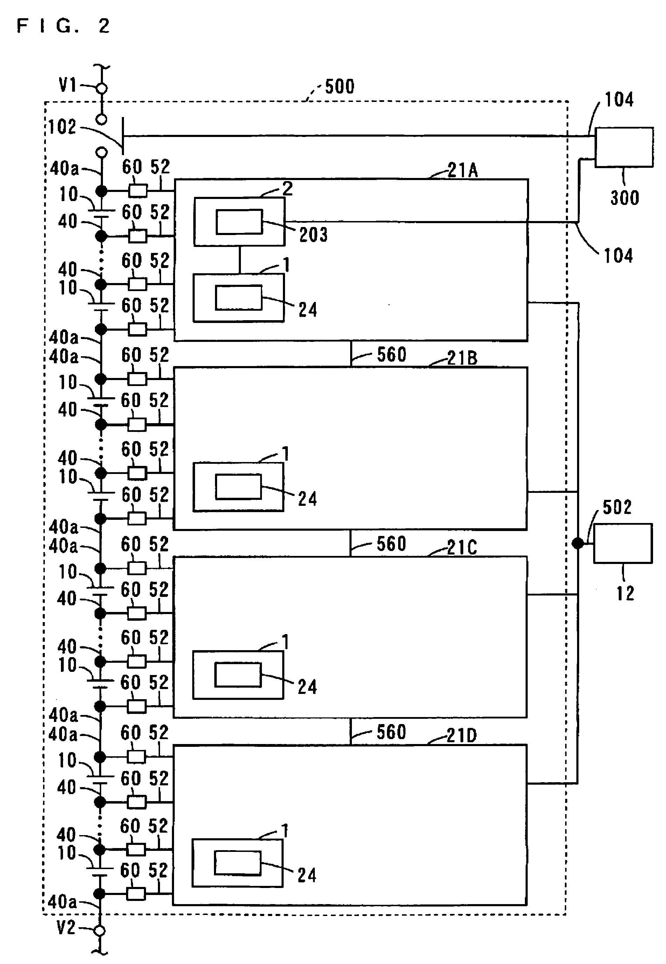

Fig. 2 is a block diagram showing the configurations of printed circuit boards 21A to 21D. As shown in Fig. 2, each of the printed circuit boards 21A to 21 D has a cell characteristics detecting circuit 1 having a cell characteristics detecting function for detecting cell characteristics such as voltage and temperature of the plurality of battery cells 10 of the corresponding battery module 100 mounted thereon. In the example of Fig. 1, each cell characteristics detecting circuit 1 can detect the cell characteristics of the eighteen battery cells 10 of the corresponding battery module 100.

As well as the cell characteristics detecting circuit 1, a control-related circuit 2 having a function different from the cell characteristics detecting function for each battery cell 10 is mounted on the printed circuit board 21A. The control-related circuit 2 includes a CAN (Controller Area Network) communication circuit 203 in the present embodiment.

The CAN communication circuit 203 includes a CPU (Central Processing Unit), a memory and an interface circuit, for example. A battery 12 of the electric vehicle is connected to the CAN communication circuit 203 through a DC-DC converter, not shown, and a power supply line 502. The battery 12 is not used as an electric power source for driving the electric vehicle. Hereinafter, the battery 12 is referred to as a non-driving battery 12. The non-driving battery 12 is used as a power source of the CAN communication circuit 203. The non-driving battery 12 is a lead-acid battery in the present embodiment.

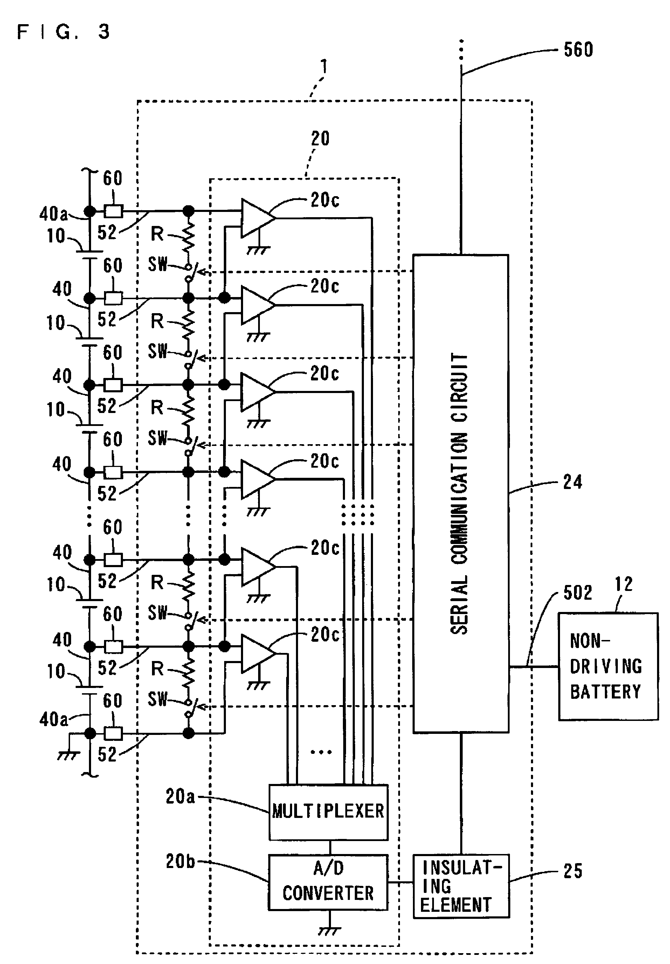

The CAN communication circuit 203 is connected to communicate with a serial communication circuit 24 (see Fig. 3) of the cell characteristics detecting circuit 1 of the printed circuit board 21A while being connected to a main controller 300 of the electric vehicle through a bus 104. As described above, the control-related circuit 2 has a CAN communication function for performing the CAN communication with the main controller 300 of the electric vehicle as a function of performing control related to the plurality of battery cells 10 in the present embodiment.

Fig. 3 is a block diagram showing the configuration of the cell characteristics detecting circuit 1. The cell characteristics detecting circuit 1 includes a voltage detecting circuit 20, the serial communication circuit 24, an insulating element 25, a plurality of resistors R and a plurality of switching elements SW. The voltage detecting circuit 20 includes a multiplexer 20a, an A/D (Analog/Digital) converter 20b and a plurality of differential amplifiers 20c.

The voltage detecting circuit 20 is composed of an ASlC (Application Specific Integrated Circuit), for example, and the plurality of battery cells 10 of the battery module 100 are used as a power source of the voltage detecting circuit 20. Each differential amplifier 20c of the voltage detecting circuit 20 has two input terminals and an output terminal. Each differential amplifier 20c differentially amplifies a voltage input to the two input terminals, and outputs the amplified voltage from the output terminal.

The two input terminals of each differential amplifier 20c are electrically connected to two adjacent bus bars 40, 40a through conductor lines 52 and PTC (Positive Temperature Coefficient) elements 60.

The PTC element 60 has such resistance temperature characteristics as to have a resistance value rapidly increasing when its temperature exceeds a certain value. Therefore, if a short occurs in the voltage detecting circuit 20 and the conductor line 52, for example, the temperature of the PTC element 60 that rises because of a current flowing through the short-circuited path causes the resistance value of the PTC element 60 to increase. Accordingly, a large current is inhibited from flowing through the short-circuited path including the PTC element 60.

The serial communication circuit 24 includes a CPU, a memory and an interface circuit, for example, and has a serial communication function and an operating function. The non-driving battery 12 of the electric vehicle is connected to the serial communication circuit 24 through the DC-DC converter, not shown, and the power supply line 502. The non-driving battery 12 is used as a power source of the serial communication circuit 24.

A series circuit composed of the resistor R and the switching element SW is connected between two adjacent bus bars 40, 40a. The main controller 300 of Fig. 1 controls the switching element SW to be turned on and off through the serial communication circuit 24. Note that the switching element SW is turned off in a normal state.

The voltage detecting circuit 20 and the serial communication circuit 24 are connected to communicate with each other while being electrically insulated from each other by the insulating element 25. A voltage between two adjacent bus bars 40, 40a is differentially amplified by each differential amplifier 20c. The output voltage from each differential amplifier 20c corresponds to a terminal voltage of each battery cell 10. The terminal voltages output from the plurality of differential amplifiers 20c are applied to the multiplexer 20a. The multiplexer 20a sequentially outputs the terminal voltages applied from the plurality of differential amplifiers 20c to the A/D converter 20b. The A/D converter 20b converts the terminal voltages output from the multiplexer 20a into digital values, and applies the digital values to the serial communication circuit 24 through the insulating element 25.

The serial communication circuit 24 is connected to the plurality of thermistors 11 of Fig. 1. This causes the serial communication circuit 24 to acquire the temperature of the battery module 100 based on output signals from the thermistors 11.

The serial communication circuits 24 (see Fig. 3) of the printed circuit boards 21 A to 21 D of Fig.2 are connected to one another through harnesses 560. This allows the serial communication circuits 24 of the printed circuit boards 21A to 21D to perform serial communication with serial communication circuits 24 of other printed circuit boards 21A to 21D. The serial communication circuits 24 of the printed circuit boards 21 B to 21 D apply the cell characteristics of each battery cell 10 to the serial communication circuit 24 of the printed circuit board 21A.

The serial communication circuit 24 (see Fig. 3) of the printed circuit board 21A of Fig. 2 is connected to the CAN communication circuit 203. The serial communication circuit 24 of the printed circuit board 21A applies the cell characteristics of the plurality of battery modules 100 to the CAN communication circuit 203. The CAN communication circuit 203 applies the cell characteristics of the plurality of battery modules 100 to the main controller 300 through the bus 104 of Fig. 1 by the CAN communication.

In the present embodiment, the main controller 300 can detect the current flowing through the plurality of battery cells 10. The main controller 300 calculates a charged capacity of each battery cell 10 based on cell information such as the cell characteristics and the current of the battery module 100, and performs charge/discharge control of each battery module 100 based on the charged capacity.

The main controller 300 also detects abnormality of each battery module 100 based on the cell information. The abnormality of the battery module 100 includes overdischarge, overcharge or abnormal temperature of the battery cells 10, for example.

The contactor 102 is inserted in the power supply line 501 connected to the battery module 100 at one end of the battery system 500. The contactor 102 is connected to the main controller 300 through the bus 104. When detecting the abnormality of the battery module 100, the main controller 300 turns off the contactor 102. Since the current does not flow through each battery module 100 in the case of an occurrence of the abnormality, the battery module 100 is prevented from being abnormally heated.

The main controller 300 controls power of the electric vehicle (a rotational speed of the motor, for example) based on the charged capacity of each battery module 100. When the charged capacity of each battery module 100 decreases, the main controller 300 controls a power generating system, not shown, connected to the power supply line 501 to cause each battery module 100 to be charged.

The motor connected to the power supply line 501, for example, functions as the power generating system in the present embodiment. In this case, the motor converts electric power supplied from the battery system 500 into mechanical power for driving drive wheels, not shown, at the time of acceleration of the electric vehicle. The motor generates regenerated electric power at the time of deceleration of the electric vehicle. Each battery module 100 is charged with the regenerated electric power.

### (2) Details of the Battery Module

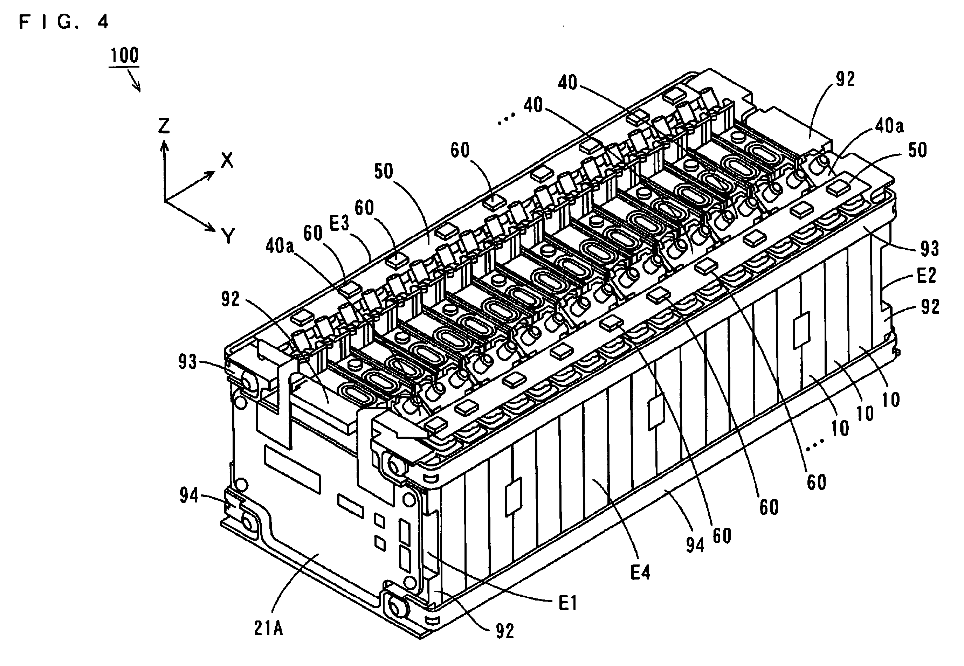

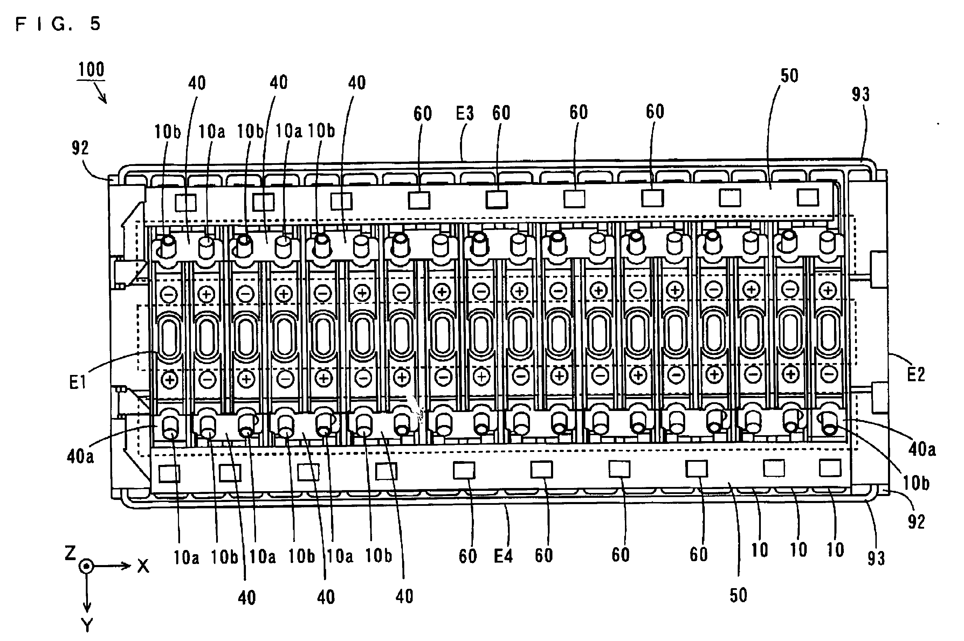

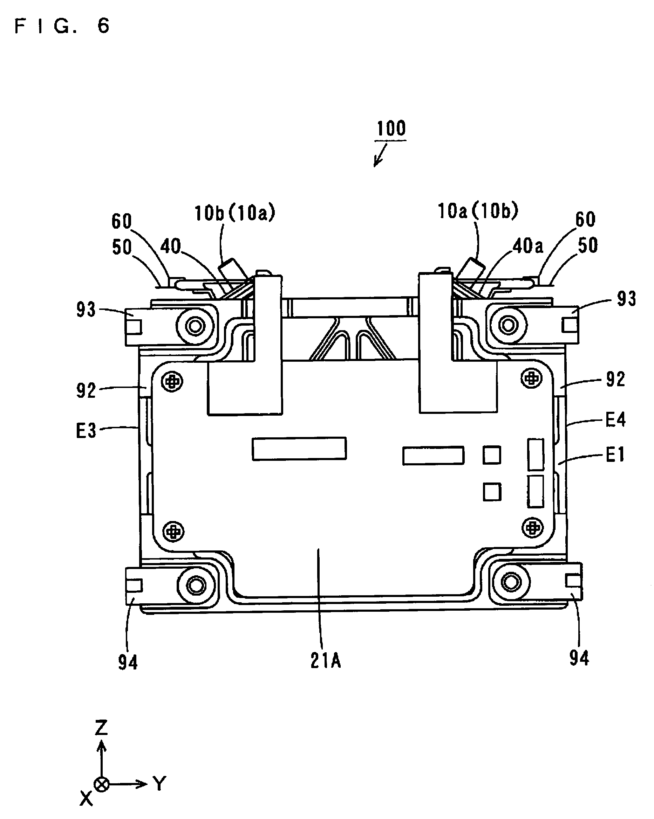

Description is made of details of the battery module 100. Fig. 4 is an external perspective view of the battery module 100, Fig. 5 is a plan view of the battery module 100, and Fig. 6 is an end view of the battery module 100.

ln Figs. 4 to 6 and Figs. 8, 9, and 17 described below, three directions that are perpendicular to one another are defined as an X-direction, a Y-direction and a Z-direction as indicated by the arrows X, Y, Z. The X-direction and the Y-direction are parallel to a horizontal plane, and the Z-direction is perpendicular to the horizontal plane in this example.

As shown in Figs. 4 to 6, the plurality of battery cells 10 each having a flat and substantially rectangular parallelepiped shape are arranged to line up in the X-direction in the battery module 100. In this state, the plurality of battery cells 10 are integrally fixed by a pair of end surface frames 92, a pair of upper end frames 93 and a pair of lower end frames 94.

Each of the pair of end surface frames 92 has a substantially plate shape, and is arranged parallel to the YZ plane. The pair of upper end frames 93 and the pair of lower end frames 94 are arranged to extend in the X-direction.

Connection portions for connecting the pair of upper end frames 93 and the pair of lower end frames 94 thereto are formed at four corners of each of the pair of end surface frames 92. The pair of upper end frames 93 is attached to the upper connection portions of the pair of end surface frames 92, and the pair of lower end frames 94 is attached to the lower connection portions of the pair of end surface frames 92 while the plurality of battery cells 10 are arranged between the pair of end surface frames 92. Accordingly, the plurality of battery cells 10 are integrally fixed while being arranged to line up in the X-direction.

The battery module 100 has end surfaces E1, E2 on the pair of end surface frames 92, respectively, as end surfaces at both ends in the X-direction. The battery module 100 has side surfaces E3, E4 along the Y-direction.

The printed circuit board 21A is attached to the end surface E1 of the one end surface frame 92. The printed circuit boards 21 B to 21 D are attached to one end surface frames 92 of the other three battery modules 100 (see Fig. 1), respectively.

Here, the plurality of battery cells 10 each have a plus electrode 10a arranged on an upper surface portion on one end side or the other end side in the Y-direction, and have a minus electrode 10b arranged on an upper surface portion on the opposite side. Each of the electrodes 10a, 10b is provided to be inclined and project upward (see Fig. 6).

In the following description, the battery cell 10 adjacent to the end surface frame 92 to which the printed circuit board 21 A is not attached to the battery cell 10 adjacent to the end surface frame 92 to which the printed circuit board 21A is attached are referred to as a first battery cell 10 to an eighteenth battery cell 10.

ln the battery module 100, the battery cells 10 are arranged such that the positional relationship between the plus electrode 10a and the minus electrode 10b of each battery cell 10 in the Y-direction is opposite to that of the adjacent battery cell 10, as shown in Fig. 5.

Thus, in two adjacent battery cells 10, the plus electrode 10a of one battery cell 10 is in close proximity to the minus electrode 10b of the other battery cell 10, and the minus electrode 10b of the one battery cel1 10 is in close proximity to the plus electrode 10a of the other battery cell 10. In this state, the bus bar 40 is attached to the two electrodes being in close proximity to each other. This causes the plurality of battery cells 10 to be connected in series.

More specifically, the common bus bar 40 is attached to the plus electrode 10a of the first battery cell 10 and the minus electrode 10b of the second battery cell 10. The common bus bar 40 is attached to the plus electrode 10a of the second battery cell 10 and the minus electrode 10b of the third battery cell 10. Similarly, the common bus bar 40 is attached to the plus electrode 10a of each of the odd numbered battery cells 10 and the minus electrode 10b of each of the even numbered battery cells 10 adjacent thereto. The common bus bar 40 is attached to the plus electrode 10a of each of the even numbered battery cells 10 and the minus electrode 10b of each of the odd numbered battery cells 10 adjacent thereto.

The bus bar 40a for connecting the power supply line 501 (see Fig. 1) from the exterior is attached to each of the minus electrode 10b of the first battery cell 10 and the plus electrode 10a of the eighteenth battery cell 10.

A long-sized flexible printed circuit board (hereinafter abbreviated as an FPC board) 50 extending in the X-direction is connected in common to the plurality of bus bars 40 on the one end side of the plurality of battery cells 10 in the Y-direction. Similarly, a long-sized FPC board 50 extending in the X-direction is connected in common to the plurality of bus bars 40, 40a on the other end side of the plurality of battery cells 10 in the Y-direction.

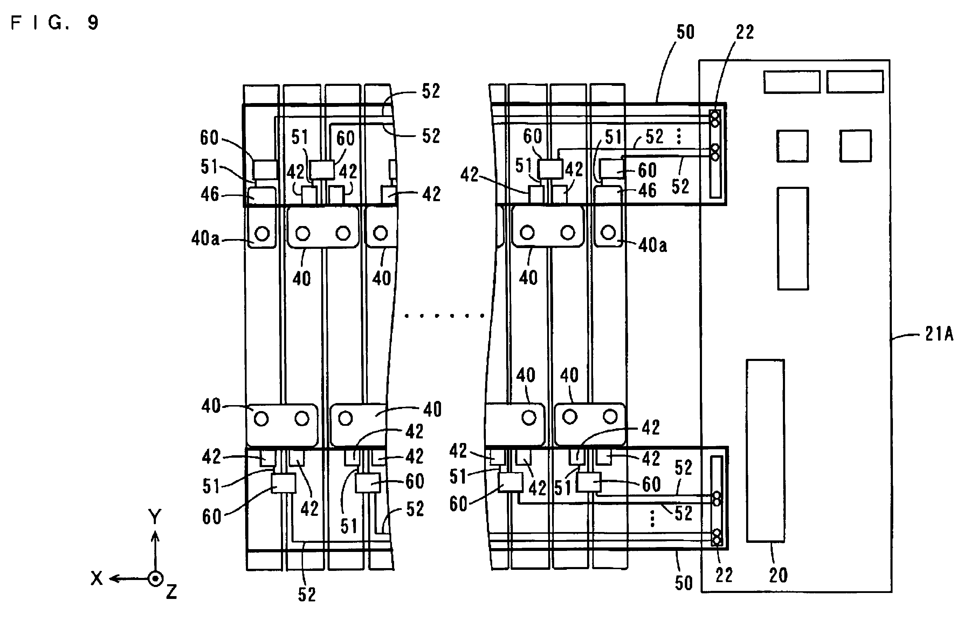

The FPC board 50 having bending characteristics and flexibility mainly includes a plurality of conductor lines 51, 52 (see Fig. 9, described below) formed on an insulating layer. Examples of the material for the insulating layer constituting the FPC board 50 include polyimide, and examples of the material for the conductor lines 51, 52 (see Fig. 9, described below) include copper. The PTC elements 60 are arranged in close proximity to the bus bars 40, 40a, respectively, on the FPC boards 50.

Each FPC board 50 is bent inward at a right angle and further bent downward at an upper end portion of the end surface frame 92 (the end surface frame 92 to which the printed circuit board 21A is attached) to be connected to the printed circuit board 21A.

### (3) The Configurations of the Bus Bars and the FPC Boards

Next, description is made of details of the configurations of the bus bars 40, 40a and the FPC boards 50. ln the following paragraphs, the bus bar 40 for connecting the plus electrode 10a and the minus electrode 10b of two adjacent battery cells 10 is referred to as the bus bar for two electrodes 40, and the bus bar 40a for connecting the plus electrode 10a or the minus electrode 10b of one battery cell 10 and the power supply line 501 is referred to as the bus bar for one electrode 40a.

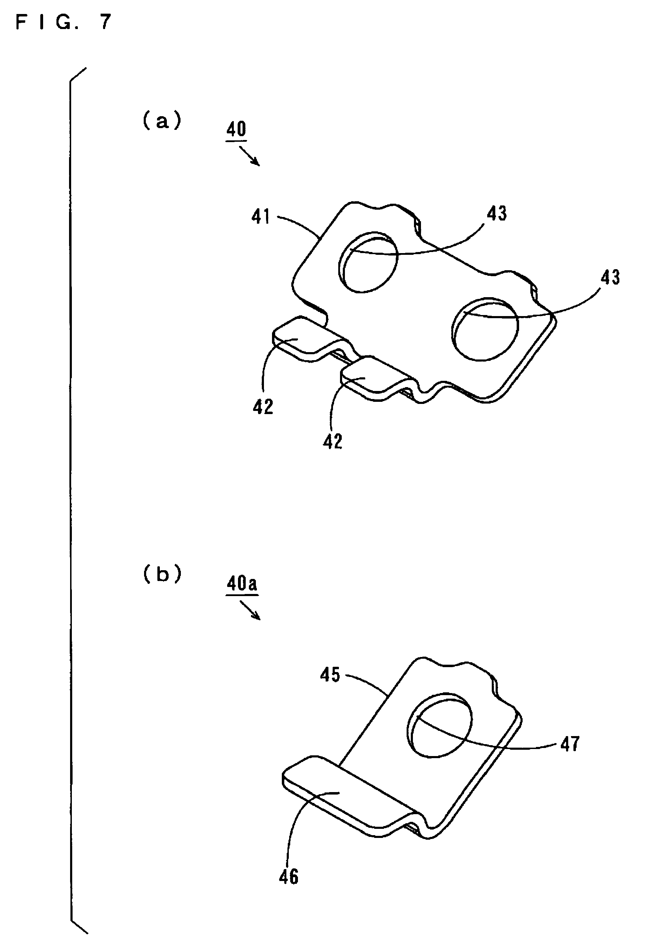

Fig. 7 (a) is an external perspective view of the bus bar for two electrodes 40, and Fig. 7 (b) is an external perspective view of the bus bar for one electrode 40a.

As shown in Fig. 7 (a), the bus bar for two electrodes 40 includes a base portion 41 having a substantially rectangular shape and a pair of attachment portions 42 that is bent and extends from one side of the base portion 41 toward one surface side. A pair of electrode connection holes 43 is formed in the base portion 41.

As shown in Fig. 7 (b), the bus bar for one electrode 40a includes a base portion 45 having a substantially square shape and an attachment portion 46 that is bent and extends from one side of the base portion 45 toward one surface side. An electrode connection hole 47 is formed in the base portion 45.

ln the present embodiment, the bus bars 40, 40a are each composed of tough pitch copper having a nickel-plated surface, for example.

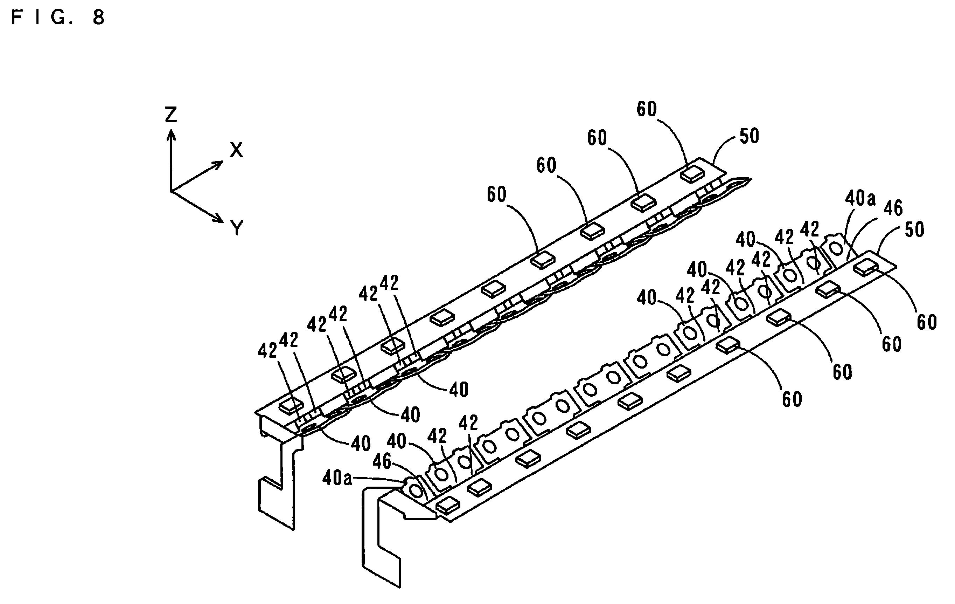

Fig. 8 is an external perspective view of the FPC boards 50 to which the plurality of bus bars 40, 40a and the plurality of PTC elements 60 are attached. As shown in Fig. 8, the attachment portions 42, 46 of the plurality of bus bars 40, 40a are attached to the two FPC boards 50 at spacings along the X-direction. The plurality of PTC elements 60 are attached to the two FPC boards 50 at the same spacings as the spacings between the plurality of bus bars 40, 40a.

The two FPC boards 50 having the plurality of bus bars 40, 40a and the plurality of PTC elements 60 attached thereto in the foregoing manner are attached to the plurality of battery cells 10 that are integrally fixed by the end surface frames 92 (see Fig. 4), the upper end frames 93 (see Fig. 4) and the lower end frames 94 (see Fig. 4) during the manufacture of the battery module 100.

During the mounting, the plus electrode 10a and the minus electrode 10b of the adjacent battery cells 10 are fitted in the electrode connection holes 43 formed in each bus bar 40. A male thread is formed at each of the plus electrodes 10a and the minus electrodes 10b. With each of the bus bars 40 fitted with the plus electrode 10a and minus electrode 10b of the adjacent battery cells 10, the male threads of the plus electrodes 10a and the minus electrodes 10b are screwed in nuts (not shown).

Similarly, the plus electrode 10a of the eighteenth battery cell 10 and the minus electrode 10b of the first battery cells 10 are fitted in the electrode connection holes 47 formed in the bus bars 40a, respectively. With the bus bars 40a fitted with the plus electrode 10a and minus electrode 10b, respectively, the male threads of the plus electrode 10a and the minus electrode 10b are screwed in nuts (not shown).

In this manner, the plurality of bus bars 40, 40a are attached to the plurality of battery cells 10 while the FPC boards 50 are held in a substantially horizontal attitude by the plurality of bus bars 40, 40a.

### (4) Connection between the Bus Bars and the Voltage Detecting Circuit

Description is made of connection between the bus bars 40, 40a and the voltage detecting circuit 20. Fig. 9 is a schematic plan view for explaining connection between the bus bars 40, 40a and the voltage detecting circuit 20. While description is made of connection between the voltage detecting circuit 20 of the printed circuit board 21A and the bus bars 40, 40a, the voltage detecting circuits 20 of the printed circuit boards 21 B to 21 D of Fig. 1 and the bus bars 40, 40a are connected in the same manner as the voltage detecting circuit 20 of the printed circuit board 21A and the bus bars 40, 40a.

As shown in Fig. 9, each FPC board 50 is provided with the plurality of conductor lines 51, 52 that correspond to the plurality of bus bars 40, 40a, respectively. Each conductor line 51 is provided to extend parallel to the Y-direction between the attachment portion 42, 46 of the bus bar 40, 40a and the PTC element 60 arranged in the vicinity of the bus bar 40, 40a. Each conductor line 52 is provided to extend parallel to the X-direction between the PTC element 60 and one end of the FPC board 50.

One end of each conductor line 51 is provided to be exposed on a lower surface of the FPC board 50. The one end of each conductor line 51 exposed on the lower surface is electrically connected to the attachment portion 42, 46 of the bus bar 40, 40a by soldering or welding, for example. Accordingly, the FPC board 50 is fixed to each of the bus bars 40, 40a.

The other end of each conductor line 51 and one end of each conductor line 52 are provided to be exposed on an upper surface of the FPC board 50. A pair of terminals (not shown) of the PTC element 60 is connected to the other end of each conductor line 51 and the one end of each conductor line 52 by soldering, for example.

Each of the PTC elements 60 is preferably arranged in a region between both ends in the X-direction of the corresponding bus bar 40, 40a. When stress is applied to the FPC board 50, a region of the FPC board 50 between the adjacent bus bars 40, 40a is easily deflected. However, the region of the FPC board 50 between the both ends of each of the bus bars 40, 40a is kept relatively flat because it is fixed to the bus bar 40, 40a. Therefore, each of the PTC elements 60 is arranged within the region of the FPC board 50 between both the ends of each of the bus bars 40, 40a, so that connectivity between the PTC element 60 and the conductor lines 51, 52 is sufficiently ensured. Moreover, the effect of deflection of the FPC board 50 on each of the PTC elements 60 (e.g., a change in the resistance value of the PTC element 60) is suppressed.

A plurality of connection terminals 22 are provided in the printed circuit board 21A corresponding to the plurality of conductor lines 52, respectively, of the FPC boards 50. The connection terminals 22 are electrically connected to the voltage detecting circuit 20. The other ends of the conductor lines 52 of the FPC boards 50 are connected to the corresponding connection terminals 22 by soldering or welding, for example. Note that the printed circuit board 21A and the FPC boards 50 may not be connected by soldering or welding. For example, connecters may be used for connecting the printed circuit board 21A and the FPC boards 50.

ln this manner, each of the bus bars 40, 40a is electrically connected to the voltage detecting circuit 20 via the PTC element 60. This causes the terminal voltage of each battery cell 10 to be detected.

### (5) Example of the Configuration of the Printed Circuit Board

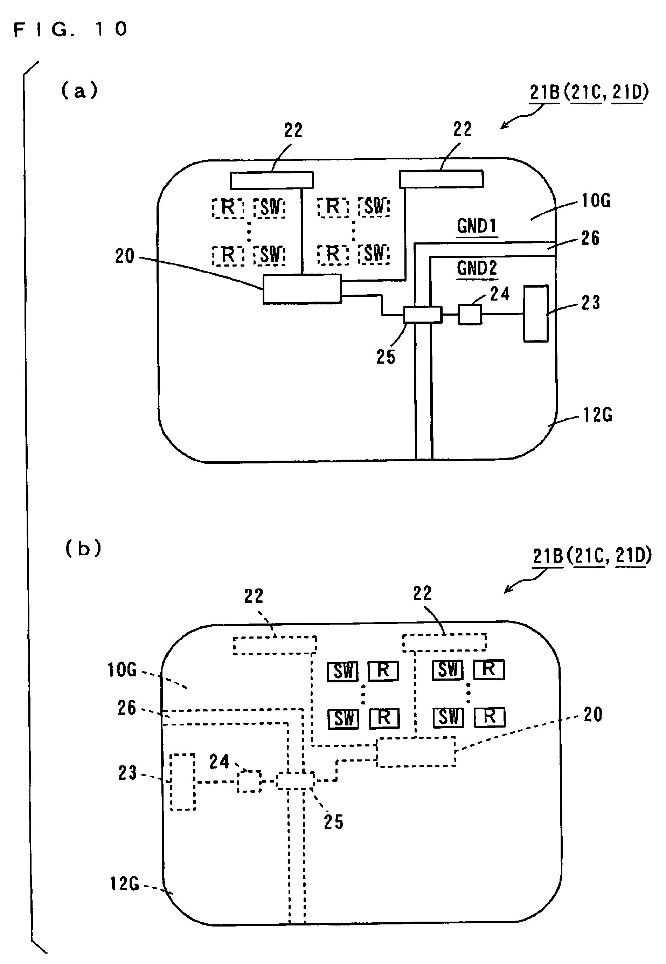

Next, description is made of one example of the configurations of the printed circuit boards 21 B to 21 D. Fig. 10 is a schematic plan view showing one example of the configuration of the printed circuit board 21 B. The configuration of each of the printed circuit boards 21 C, 21 D is the same as the configuration of the printed circuit board 21 B.

The printed circuit board 21 B has a substantially rectangular shape, and has one surface and the other surface. (a) and (b) in Fig. 10 show the one surface and the other surface of the printed circuit board 21 B, respectively.

As shown in Fig. 10 (a), the voltage detecting circuit 20, the serial communication circuit 24 and the insulating element 25 are mounted on the one surface of the printed circuit board 21 B. ln addition, the connection terminals 22 and a connector 23 are formed on the one surface of the printed circuit board 21 B. As shown in Fig. 10 (b), the plurality of resistors R and the plurality of switching elements SW are mounted on the other surface of the printed circuit board 21 B.

The plurality of resistors R on the other surface of the printed circuit board 21B are arranged above a position corresponding to the voltage detecting circuit 20. This allows heat generated in the resistors R to be efficiently released. Moreover, the heat generated in the resistors R can be prevented from being transmitted to the voltage detecting circuit 20. This prevents an occurrence of malfunctions and deterioration of the voltage detecting circuit 20 to be caused by heat.

The connection terminals 22 are arranged in the vicinity of an upper end of the printed circuit board 21 B. This allows the length of the FPC boards 50 (see Fig. 9) connected to the connection terminals 22 to be reduced.

The printed circuit board 21 B has a first mounting region 10G, a second mounting region 12G and a strip-shaped insulating region 26.

The second mounting region 12G is formed at one corner of the printed circuit board 21 B. The insulating region 26 is formed to extend along the second mounting region 12G. The first mounting region 10G is formed in the remaining part of the printed circuit board 21B. The first mounting region 10G and the second mounting region 12G are separated from each other by the insulating region 26. Thus, the first mounting region 10G and the second mounting region 12G are electrically insulated from each other by the insulating region 26.

The voltage detecting circuit 20 is mounted and the connection terminals 22 are formed on the first mounting region 10G. The voltage detecting circuit 20 and each connection terminal 22 are electrically connected to each other through connecting lines on the printed circuit board 21B. The plurality of battery cells 10 (see Fig. 1) of the battery module 100 are connected to the voltage detecting circuit 20 as the power source of the voltage detecting circuit 20. A ground pattern GND1 is formed on part of the first mounting region 10G not including the mounting region of the voltage detecting circuit 20, the formation region of the connection terminals 22 and the formation region of the connecting lines. The ground pattern GND1 is held at a reference potential of the battery module 100.

The serial communication circuit 24 is mounted and the connector 23 is formed on the second mounting region 12G, and the serial communication circuit 24 and the connector 23 are electrically connected to each other through a plurality of connecting lines on the printed circuit board 21 B. The harness 560 of Fig. 1 is connected to the connector 23. The non-driving battery 12 (see Fig. 1) included in the electric vehicle is connected to the serial communication circuit 24 as the power source of the serial communication circuit 24. A ground pattern GND2 is formed on part of the second mounting region 12G not including the mounting region of the serial communication circuit 24, the formation region of the connector 23 and the formation region of the plurality of connecting lines. The ground pattern GND2 is held at a reference potential of the non-driving battery 12.

The insulating element 25 is mounted over the insulating region 26. The insulating element 25 electrically insulates the ground pattern GND1 and the ground pattern GND2 from each other while transmitting a signal between the voltage detecting circuit 20 and the serial communication circuit 24. For example, a digital isolator, a photocoupler or the like can be used as the insulating element 25. In the present embodiment, a digital isolator is used as the insulating element 25.

ln this manner, the voltage detecting circuit 20 and the serial communication circuit 24 are electrically insulated from each other while being connected to communicate with each other by the insulating element 25. Thus, the plurality of battery cells 10 can be used as the power source of the voltage detecting circuit 20, and the non-driving battery 12 (see Fig. 1) can be used as the power source of the serial communication circuit 24. As a result, each of the voltage detecting circuit 20 and the serial communication circuit 24 can be stably and independently operated.

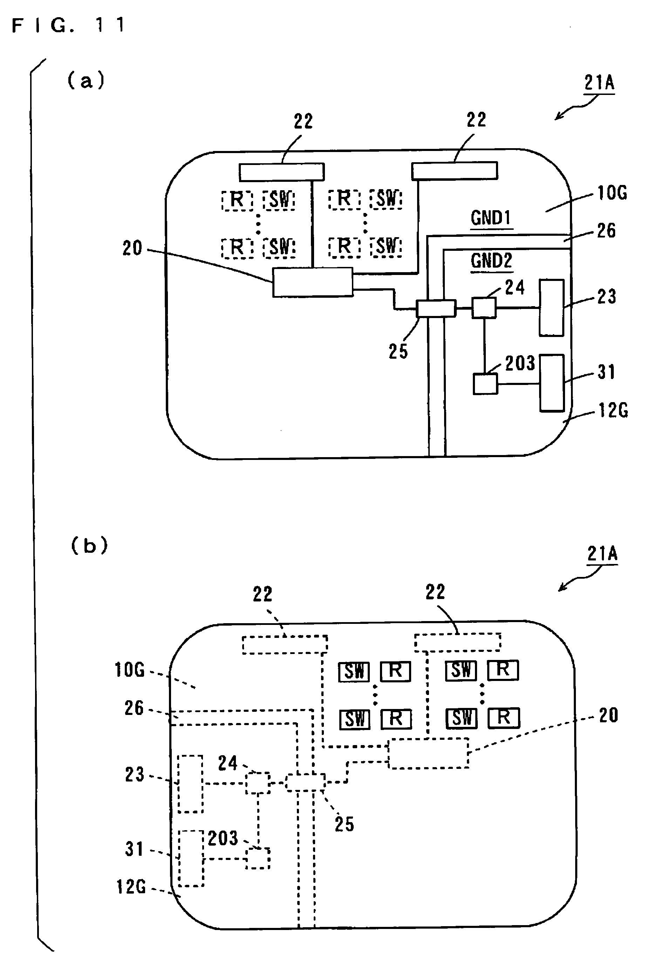

Next, description is made of one example of the configuration of the printed circuit board 21A. The printed circuit board 21A is described by referring to differences from the printed circuit boards 21 B to 21 D. Fig. 11 is a schematic plan view showing one example of the configuration of the printed circuit board 21A. The printed circuit board 21A has a substantially rectangular shape, and has one surface and the other surface. (a) and (b) in Fig. 11 show one surface and the other surface of the printed circuit board 21A, respectively.

As shown in Fig. 11 (a), the CAN communication circuit 203 and a connector 31 in addition to the serial communication circuit 24 and the connector 23 are formed on the second mounting region 12G. The CAN communication circuit 203 and the serial communication circuit 24 are electrically connected to each other through a plurality of connecting lines on the printed circuit board 21A. The CAN communication circuit 203 and the connector 31 are electrically connected to each other through a plurality of connecting lines on the printed circuit board 21A. The connector 31 is connected to the bus 104 of Fig. 1.

The non-driving battery 12 (see Fig. 1) included in the electric vehicle is connected to the CAN communication circuit 203 as the power source of the CAN communication circuit 203. The ground pattern GND2 is formed on part of the second mounting region 12G not including the mounting region of the serial communication circuit 24 and the CAN communication circuit 203, the formation region of the connectors 23, 31 and the formation region of the plurality of connecting lines. The ground pattern GND2 is held at the reference potential of the non-driving battery 12.

As shown in Fig. 11 (b), the configuration of the other surface of the printed circuit board 21A is the same as that of the other surface of the printed circuit board 21 B of Fig. 10 (b).

### (6) Equalization of Voltages of the Battery Cells

The main controller 300 of Fig. 1 calculates the charged capacity of each battery cell 10 from the cell information of each battery cell 10 in each battery module 100. Here, when detecting that a charged capacity of one battery cell 10 is larger than each of charged capacities of the other battery cells 10, the main controller 300 turns on the switching element SW (see Fig. 3) connected to the battery cell 10 having the larger charged capacity through the serial communication circuits 24 of the printed circuit boards 21A to 21 D.

Thus, charges stored in the battery cell 10 are discharged through the resistor R (see Fig. 3). When the charged capacity of the battery cell 10 decreases to be substantially equal to each of the charged capacities of the other battery cells 10, the main controller 300 turns off the switching element SW connected to the battery cell 10.

ln this manner, charged capacities of all the battery cells 10 are kept substantially equal. This prevents part of the battery cells 10 from being excessively charged or discharged. As a result, deterioration of the battery cells 10 can be prevented.

The plurality of resistors R are distributed in the printed circuit boards 21A to 21 D. This allows heat generated during discharge of the plurality of battery cell 10 to be efficiently released. As a result, the cell characteristics detecting circuits 1 of the printed circuit boards 21A to 21 D and the control-related circuit 2 of the printed circuit board 21A can be prevented from being deteriorated.

### (7) Connection and Wiring among the Battery Modules

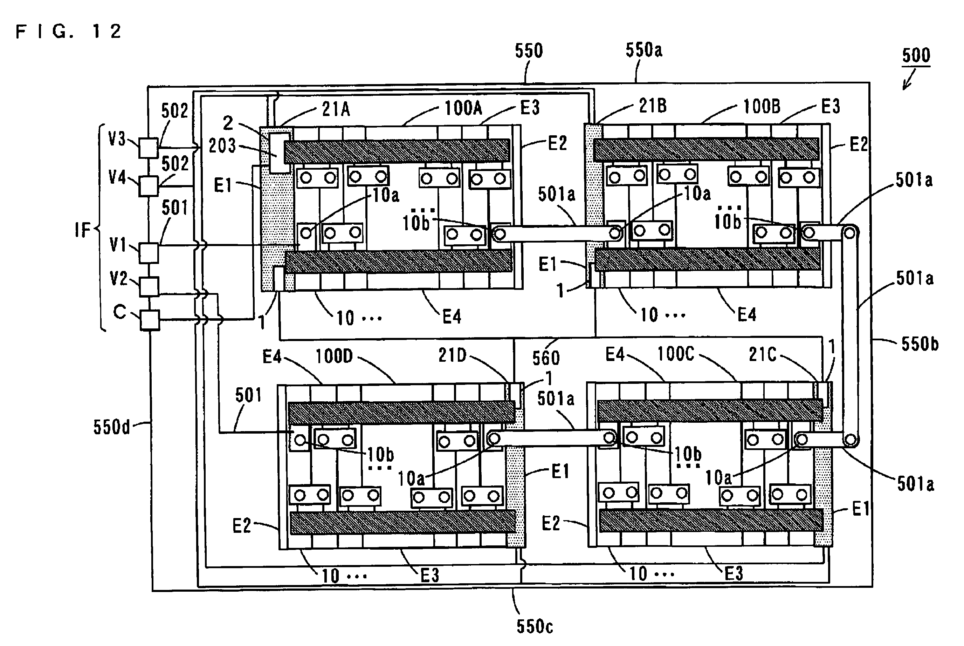

Next, description is made of connection and wiring among the battery modules 100. Fig. 12 is a schematic plan view showing one example of connection and wiring among the battery modules 100 in the battery system 500.

As shown in Fig. 12, the four battery modules 100 are referred to as battery modules 100A, 100B, 100C, 100D for distinction. The battery modules 100A to 100D are provided with the printed circuit boards 21A to 21 D, respectively.

A casing 550 has side walls 550a, 550b, 550c, 550d. The side walls 550a, 550c are parallel to each other, and the side walls 550b, 550d are parallel to each other and perpendicular to the side walls 550a, 550c. The four battery modules 100A to 100D are arranged to form two rows and two columns within the casing 550.

More specifically, the end surface E2 of the battery module 100A and the end surface E1 of the battery module 100B are arranged to face each other, and the end surface E1 of the battery module 100D and the end surface E2 of the battery module 100C are arranged to face each other. The side surface E4 of the battery module 100A and the side surface E4 of the battery module 100D are arranged to face each other, and the side surface E4 of the battery module 100B and the side surface E4 of the battery module 100C are arranged to face each other. The end surface E1 of the battery module 100A and the end surface E2 of the battery module 100D are arranged to be directed to the side wall 550d, and the end surface E2 of the battery module 100B and the end surface E1 of the battery module 100C are arranged to be directed to the side wall 550b. An external interface lF including a communication terminal C and voltage terminals V1 to V4 is provided on the side wall 550d.

The serial communication circuits 24 (see Fig. 3) of the cell characteristics detecting circuits 1 of the printed circuit boards 21A to 21D are connected to one another through the harnesses 560. A minus electrode 10b having the lowest potential in the battery module 100A and a plus electrode 10a having the highest potential in the battery module 100B are connected through a bus bar 501a. A minus electrode 10b having the lowest potential in the battery module 100B and a plus electrode 10a having the highest potential in the battery module 100C are connected through a bus bar 501 a. A minus electrode 10b having the lowest potential in the battery module 100C and a plus electrode 10a having the highest potential in the battery module 100D are connected through a bus bar 501a.

A plus electrode 10a having the highest potential in the battery module 100A is connected to the voltage terminal V1 through the power supply line 501. A minus electrode 10b having the lowest potential in the battery module 100D is connected to the voltage terminal V2 through the power supply line 501. ln this case, the motor or the like of the electric vehicle is connected between the voltage terminals V1, V2, so that electric power generated in the battery modules 100A to 100D connected in series can be supplied to the motor or the like.

The CAN communication circuit 203 (see Fig. 2) of the control-related circuit 2 of the printed circuit board 21A is connected to the main controller 300 of Fig. 1 through the bus 104 via the communication terminal C. This allows the CAN communication circuit 203 of the printed circuit board 21A and the main controller 300 to communicate with each other.

The DC-DC converter, not shown, of each of the printed circuit boards 21A to 21D is connected to the non-driving battery 12 of Fig. 1 through the power supply line 502 via the voltage terminals V3, V4. This causes the electric power to be supplied to the cell characteristics detecting circuits 1 and the control-related circuit 2 of the printed circuit boards 21A to 21 D.

### (8) Effects

In the battery system 500 according to the present embodiment, the cell characteristics detecting circuit 1 having the cell characteristics detecting function for detecting the cell characteristics of each battery cell 10 is mounted on each of the printed circuit boards 21A to 21 D. As well as the cell characteristics detecting circuit 1, the control-related circuit 2 having the CAN communication function is further mounted on the printed circuit board 21A.

ln this case, the wiring between the cell characteristics detecting circuit 1 and the CAN communication circuit 203 is formed on the printed circuit board 21A. A controlling unit having the CAN communication function need not be separately provided in the battery system 500. Accordingly, the wiring of the battery system 500 can be simplified, and the battery system 500 can be reduced in size.

### [2] Second Embodiment

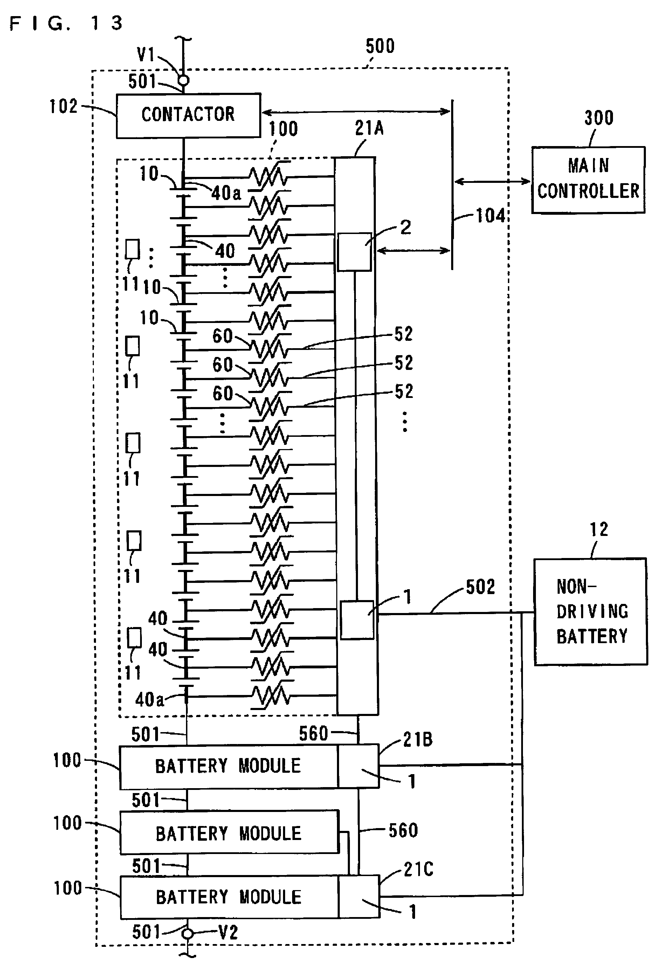

Description will be made of a battery system according to a second embodiment by referring to differences from the battery system 500 according to the first embodiment. Fig. 13 is a block diagram showing the configuration of the battery system 500 according to the second embodiment.

As shown in Fig. 13, the number of printed circuit boards 21A to 21C is different from the number of the battery modules 100 in the battery system 500 according to the second embodiment. In the example of Fig. 13, the three printed circuit boards 21Ato 21C are provided corresponding to three of the four battery modules 100 in the battery system 500.

Each of the printed circuit boards 21A, 21 B has the cell characteristics detecting circuit 1 having the cell characteristics detecting function for detecting the cell characteristics of the plurality of battery cells 10 of the corresponding battery module 100 mounted thereon. In the example of Fig. 13, the cell characteristics detecting circuit 1 of each of the printed circuit boards 21A, 21B can detect the cell characteristics of the eighteen battery cells 10 of the corresponding battery module 100.

The printed circuit board 21C has the cell characteristics detecting circuit 1 having the cell characteristics detecting function for detecting the cell characteristics of the plurality of battery cells 10 of the corresponding battery module 100 and another battery module 100 arranged next thereto mounted thereon. In the example of Fig. 13, the cell characteristics detecting circuit 1 of the printed circuit board 21 C can detect the cell characteristics of the eighteen battery cells 10 of the corresponding battery module 100 and the eighteen battery cells 10 of the battery module 100 arranged next thereto.

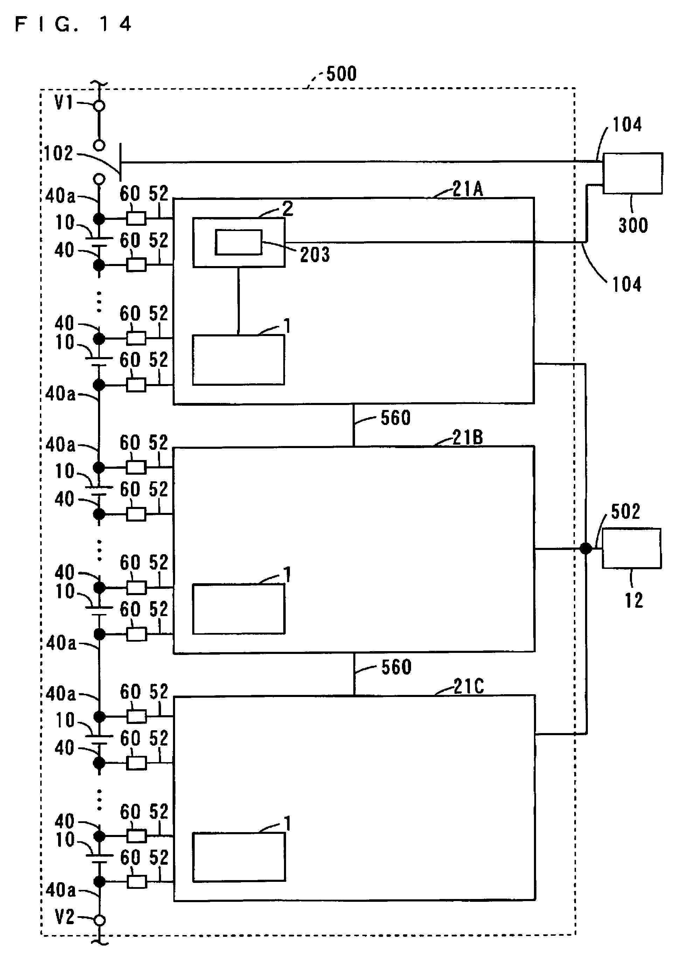

Fig. 14 is a block diagram showing the configurations of the printed circuit boards 21A to 21C in the second embodiment. As shown in Fig. 14, as well as the cell characteristics detecting circuit 1, the control-related circuit 2 having the different function from the cell characteristics detecting function of each battery cell 10 is mounted on the printed circuit board 21A. The control-related circuit 2 includes the CAN communication circuit 203. Therefore, the control-related circuit 2 has the CAN communication function for performing the CAN communication with the main controller 300 of the electric vehicle as the function of performing control related to the plurality of battery cells 10 in the present embodiment.

As described above, the printed circuit board 21C is used in common for the two battery modules 100 in the battery system 500 according to the present embodiment. Therefore, the number of the printed circuit boards 21A to 21C is smaller than the number of the battery modules 100. As a result, the battery system 500 can be further reduced in size.

### [3] Third Embodiment

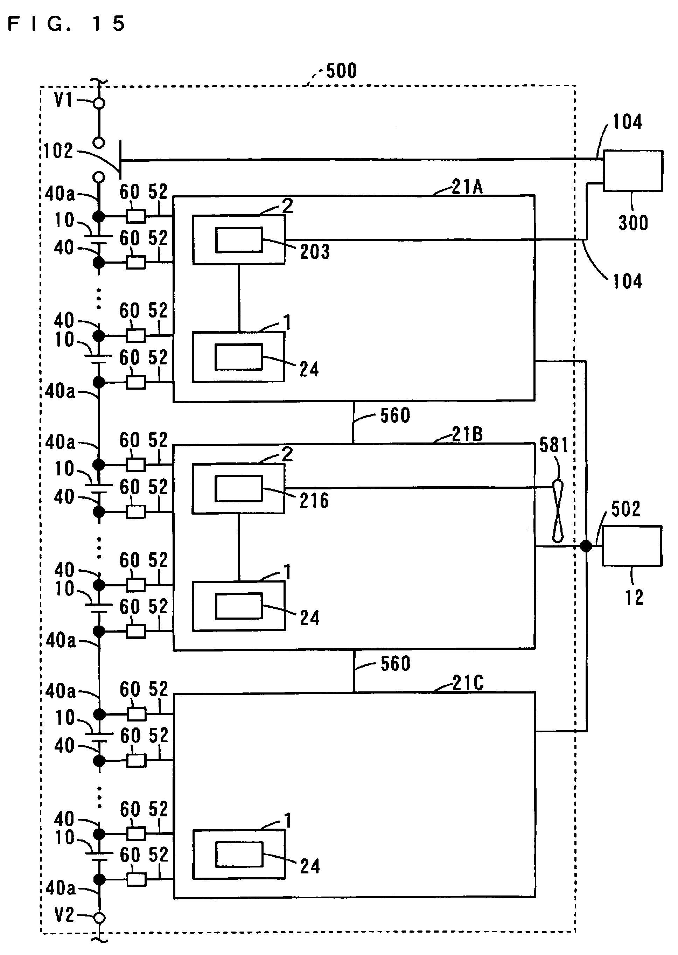

Description will be made of a battery system according to a third embodiment by referring to differences from the battery system 500 according to the second embodiment. Fig. 15 is a block diagram showing the configurations of printed circuit board 21A to 21C in the third embodiment.

As shown in Fig. 15, as well as the cell characteristics detecting circuit 1, a control-related circuit 2 including a fan controlling circuit 216 is mounted on the printed circuit board 21 B in the present embodiment. The battery system 500 further includes a fan 581 for releasing heat from the battery module 100. The fan controlling circuit 216 is connected to the cell characteristics detecting circuit 1 of the printed circuit board 21 B while being connected to the fan 581.

The main controller 300 applies the cell information of the plurality of battery modules 100 to the fan controlling circuit 216 through the CAN communication circuit 203 of the printed circuit board 21A and the serial communication circuits 24 of the cell characteristics detecting circuits 1 of the printed circuit boards 21A, 21B. The fan controlling circuit 216 controls the fan 581 to be switched on and off and controls a rotational speed of the fan 581 based on the cell information of the battery modules 100.

As described above, the control-related circuit 2 of the printed circuit board 21 B has the fan controlling function for controlling the fan 581 as a function of performing control related to the plurality of battery cells 10 in the present embodiment.

In this case, wiring between the cell characteristics detecting circuit 1 and the fan controlling circuit 216 is formed on the printed circuit board 21 B. Since the fan controlling circuit 216 controls the fan 581 using the fan controlling function, a controlling unit for controlling the fan 581 need not be separately provided in the battery system 500. Accordingly, the wiring of the battery system 500 can be further simplified, and the battery system 500 can be further reduced in size.

### [4] Fourth Embodiment

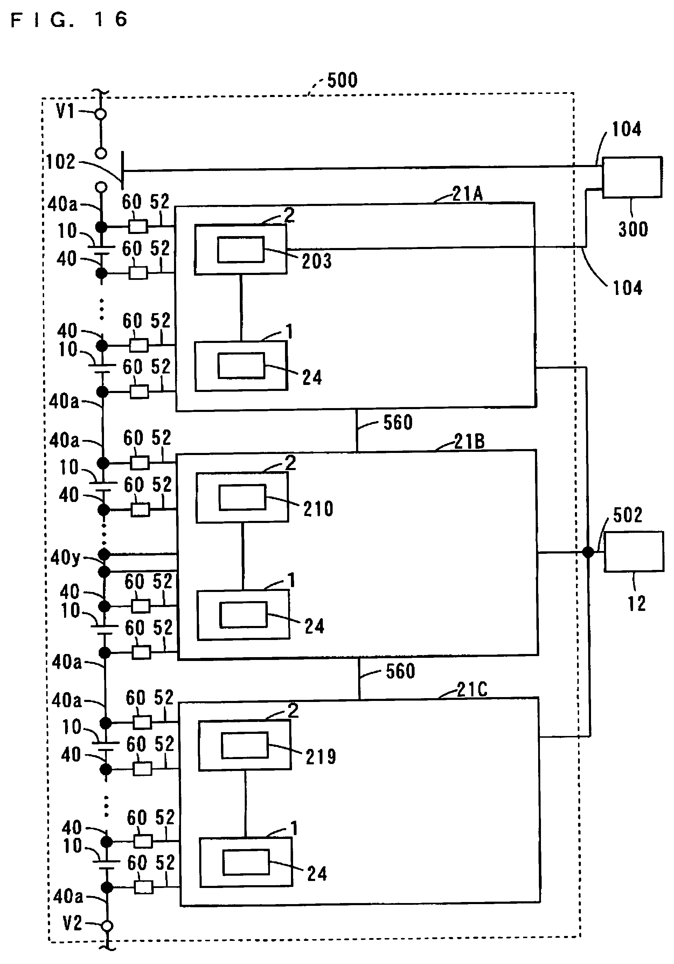

Description will be made of a battery system according to a fourth embodiment by referring to differences from the battery system 500 according to the second embodiment. Fig. 16 is a block diagram showing the configurations of printed circuit boards 21A to 21 C in the fourth embodiment.

As shown in Fig. 16, as well as the cell characteristics detecting circuit 1, a control-related circuit 2 including a current detecting circuit 210 is mounted on the printed circuit board 21 B in the present embodiment. As well as the cell characteristics detecting circuit 1, a control-related circuit 2 including an operating circuit 219 is mounted on the printed circuit board 21C. Furthermore, a voltage/current bus bar 40y, described below, is provided instead of one of the plurality of bus bars 40 in the battery system 500 according to the present embodiment. The current detecting circuit 210 is connected to the cell characteristics detecting circuit 1 of the printed circuit board 21 B while being connected to the voltage/current bus bar 40y. The operating circuit 219 is connected to the cell characteristics detecting circuit 1 of the printed circuit board 21 C.

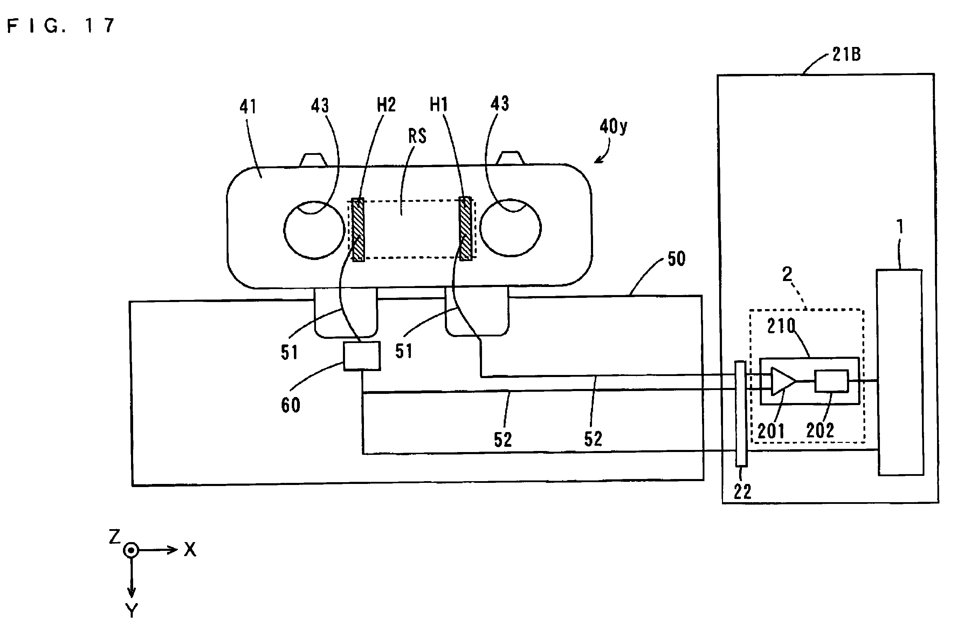

Fig. 17 is an enlarged plan view showing the voltage/current bus bar 40y and the FPC board 50 in the battery module 100. As shown in Fig. 17, the current detecting circuit 210 of the printed circuit board 21 B includes an amplifying circuit 201 and an A/D converter 202.

A pair of solder traces H1, H2 is formed in parallel with each other at a regular spacing on the base portion 41 of the voltage/current bus bar 40y. The solder trace H1 is arranged between the two electrode connection holes 43 to be close to one electrode connection hole 43, and the solder trace H2 is arranged between the electrode connection holes 43 to be close to the other electrode connection hole 43. Resistance formed between the solder traces H1, H2 of the voltage/current bus bar 40y is referred to as shunt resistance RS for current detection.

The solder trace H1 of the voltage/current bus bar 40y is connected to one input terminal of the amplifying circuit 201 of the current detecting circuit 210 through the conductor lines 51, 52 and the connection terminal 22. Similarly, the solder trace H2 of the voltage/current bus bar 40y is connected to the other input terminal of the amplifying circuit 201 through the conductor line 51, the PTC element 60, the conductor line 52 and the connection terminal 22.

The voltage between the solder traces H1, H2 amplified by the amplifying circuit 201 is converted into the digital value by the A/D converter 202, and applied to the operating circuit 219 (see Fig. 16) of the printed circuit board 21C through the serial communication circuits 24 (see Fig. 16) of the cell characteristics detecting circuits 1 of the printed circuit boards 21 B, 21 C.

The operating circuit 219 includes a CPU and a memory, for example, and has an operating function. The memory included in the operating circuit 219 previously stores a value of the shunt resistance RS between the solder traces H1, H2 of the voltage/current bus bar 40y. The CPU of the operating circuit 219 detects the voltage between the solder traces H1, H2 based on the digital value output from the A/D converter 202.

The operating circuit 219 calculates a value of the current flowing through the voltage/current bus bar 40y by dividing the voltage between the solder traces H1, H2 by the value of the shunt resistance RS stored in the memory. In this manner, the value of the current flowing through the plurality of battery cells 10 (see Fig. 1) is detected.

Furthermore, the operating circuit 219 calculates the charged capacity of each battery cell 10 from the voltage and temperature of the plurality of battery cells 10 and the current flowing through the plurality of battery cells 10. Here, when detecting that a charged capacity of one battery cell 10 is larger than each of charged capacities of the other battery cells 10, the operating circuit 219 turns on the switching element SW (see Fig. 3) connected to the battery cell 10 having the larger charged capacity through the serial communication circuits 24 of the printed circuit boards 21A to 21C.

Thus, charges stored in the battery cell 10 are discharged through the resistor R (see Fig. 3). When the charged capacity of the battery cell 10 decreases to be substantially equal to each of the charged capacities of the other battery cells 10, the operating circuit 219 turns off the switching element SW connected to the battery cell 10.

ln this manner, charged capacities of all the battery cell 10 are kept substantially equal. This prevents part of the battery cells 10 from being excessively charged or discharged. As a result, deterioration of the battery cells 10 can be prevented.

As described above, the control-related circuit 2 of the printed circuit board 21 B has a current detecting function for detecting the current flowing through the plurality of battery cells 10 in the form of voltage as a function of detecting a parameter of the plurality of battery cells 10 in the present embodiment. The control-related circuit 2 of the printed circuit board 21C has the operating function for calculating the value of the current flowing through the plurality of battery cells 10 and calculating the charged capacity of each battery cell 10 and an equalization control function for equalizing the charged capacities of the plurality of battery cells 10 as functions of performing control related to the plurality of battery cells 10.

ln this case, wiring between the cell characteristics detecting circuit 1 and the current detecting circuit 210 is formed on the printed circuit board 21 B, and wiring between the cell characteristics detecting circuit 1 and the operating circuit 219 is formed on the printed circuit board 21C. Since the current detecting circuit 210 detects the current flowing through the plurality of battery cells 10 using the current detecting function, a detecting unit for detecting the current need not be separately provided. In addition, since the operating circuit 219 calculates the value of the current and the charged capacity using the operating function, an operating unit for calculating the value of the current and the charged capacity need not be separately provided. Furthermore, since the operating circuit 219 performs equalization control of the charged capacities of the plurality of battery cells 10 using the equalization control function, a controlling unit for performing the equalization control of the charged capacities need not be separately provided. Accordingly, the wiring of the battery system 500 can be further simplified, and the battery system 500 can be further reduced in size.

### [5] Fifth Embodiment

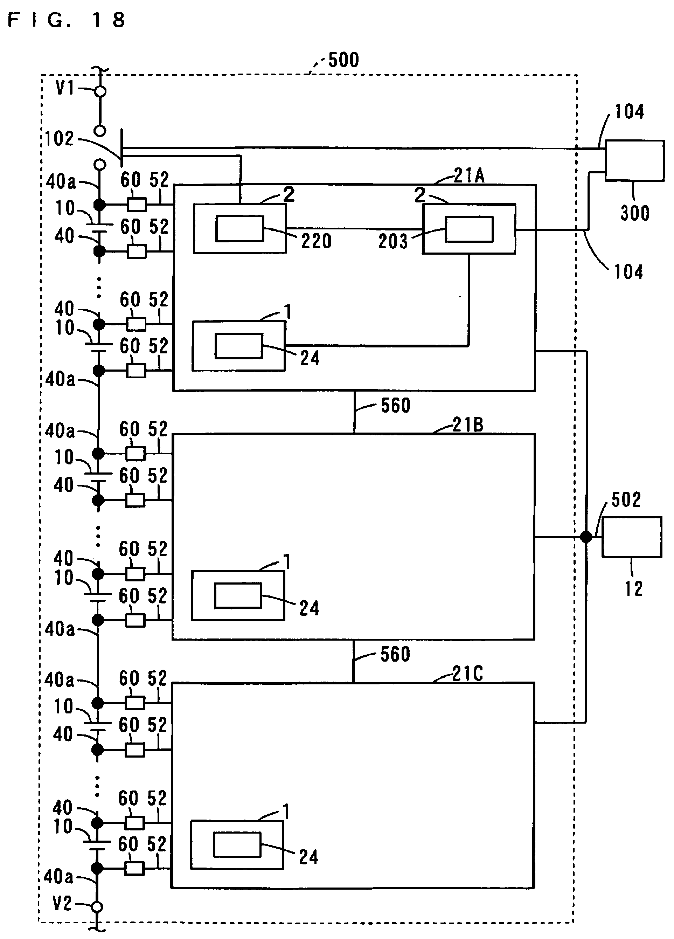

Description will be made of a battery system according to a fifth embodiment by referring to differences from the battery system 500 according to the second embodiment. Fig. 18 is a block diagram showing the configurations of printed circuit boards 21A to 21C in the fifth embodiment.

As shown in Fig. 18, as well as the cell characteristics detecting circuit 1 and the control-related circuit 2 including the CAN communication circuit 203, a control-related circuit 2 including a watchdog circuit 220 is mounted on the printed circuit board 21A in the present embodiment. The watchdog circuit 220 is connected to the CAN communication circuit 203 while being connected to the contactor 102.

The watchdog circuit 220 monitors the presence/absence of abnormality of the CPU included in the CAN communication circuit 203, for example. When the CPU is normally operated, a signal of a cycle is sent from the CPU to the watchdog circuit 220. Meanwhile, when abnormality occurs in the CPU, the signal is not sent to the watchdog circuit 220. ln this case, the watchdog circuit 220 controls the CPU to restart. This causes the CPU to recover from the abnormality.

When abnormality occurs in the CPU of the CAN communication circuit 203, the cell characteristics of each battery module 100 is not applied to the main controller 300 of the electric vehicle. Therefore, the contactor 102 is not controlled to be turned on and off even though the abnormality occurs in the battery module 100.

Therefore, the watchdog circuit 220 turns off the contactor 102 when the abnormality occurs in the CPU of the CAN communication circuit 203. This interrupts the current flowing through each battery module 100, preventing the battery modules 100 from being abnormally heated.

As described above, the control-related circuit 2 of the printed circuit board 21A has a watchdog function for controlling the CPU of the CAN communication circuit 203, for example, to restart and a contactor controlling function for controlling the contactor 102 to be turned on and off as functions of performing control related to the plurality of battery cells 10 in the present embodiment.

In this case, wiring between the CAN communication circuit 203 and the watchdog circuit 220 is formed on the printed circuit board 21A. Since the watchdog circuit 220 controls the CPU to restart using the watchdog function, a controlling unit for controlling the CPU need not be separately provided. Accordingly, the wiring of the battery system 500 can be further simplified, and the battery system 500 can be further reduced in size.

### [6] Sixth Embodiment

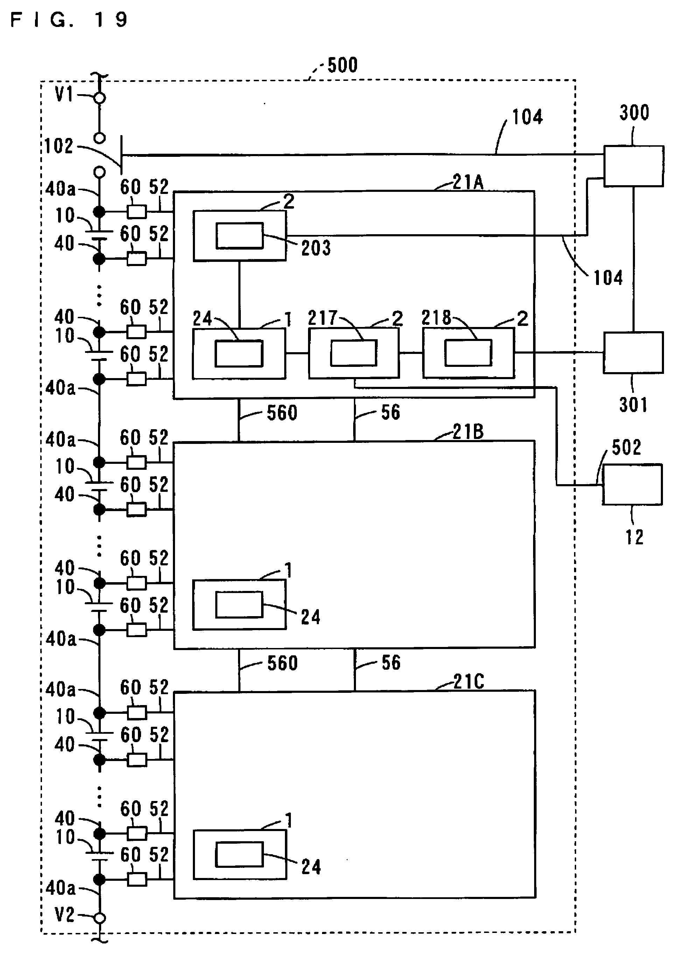

Description will be made of a battery system according to a sixth embodiment by referring to differences from the battery system 500 according to the second embodiment. Fig. 19 is a block diagram showing the configurations of printed circuit boards 21A to 21C in the sixth embodiment.

As shown in Fig. 19, in addition to the control-related circuit 2 including the CAN communication circuit 203, a control-related circuit 2 including a power supplying circuit 217 and a control-related circuit 2 including a vehicle start-up detecting circuit 218 are mounted on the printed circuit board 21A in the present embodiment. The electric vehicle includes a start-up signal generator 301 that generates a start-up signal at the time of start-up.

The power supplying circuit 217 is connected to the cell characteristics detecting circuit 1 of the printed circuit board 21A while being connected to the non-driving battery 12 through the power supply line 502. The power supplying circuit 217 is connected to the printed circuit boards 21 B, 21C through the conductor lines 56. The power supplying circuit 217 includes a DC-DC converter, and converts the voltage from the non-driving battery 12 into a low voltage.

The vehicle start-up detecting circuit 218 is connected to the power supplying circuit 217 of the printed circuit board 21A while being connected to the start-up signal generator 301. The start-up signal generator 301 is also connected to the main controller 300.

The vehicle start-up detecting circuit 218 detects the start-up signal generated by the start-up signal generator 301. When detecting the start-up signal, the vehicle start-up detecting circuit 218 starts up the power supplying circuit 217. The started power supplying circuit 217 applies the low voltage obtained by the DC-DC converter to the cell characteristics detecting circuits 1 of the plurality of printed circuit boards 21A to 21C as a power source. This causes the cell characteristics detecting circuits 1 of the plurality of printed circuit boards 21A to 21C to be started.

More specifically, the cell characteristics detecting circuit 1 of the printed circuit board 21A is started by the low voltage applied from the power supplying circuit 217 arranged on the same printed circuit board 21A. The cell characteristics detecting circuit 1 of the printed circuit board 21 B and the cell characteristics detecting circuit 1 of the printed circuit board 21C are started by the low voltages applied from the power supplying circuit 217 through the conductor lines 56.

The cell characteristics detecting circuits 1 of the printed circuit boards 21A to 21C are started, thereby starting the serial communication circuits 24. This allows for the serial communication among the printed circuit boards 21A to 21C.

The control-related circuit 2 of the printed circuit board 21A has a power supplying function for supplying electric power to the cell characteristics detecting circuits 1 of the plurality of printed circuit boards 21A to 21C as a function of supplying electric power to the plurality of printed circuit boards 21A to 21C in the present embodiment. Moreover, the control-related circuit 2 of the printed circuit board 21A has a start-up controlling function for controlling the serial communication circuit 24 of each cell characteristics detecting circuit 1 to start up in response to the start-up of the electric vehicle as a function of performing control related to the plurality of battery cells 10.

ln this case, wiring between the cell characteristics detecting circuit 1 and the power supplying circuit 217 and wiring between the power supplying circuit 217 and the vehicle start-up detecting circuit 218 are formed on the printed circuit board 21A. Since the vehicle start-up detecting circuit 218 controls each serial communication circuit 24 to start up using the start-up controlling function, a controlling unit for controlling the serial communication circuits 24 to start up need not be separately provided. Since the power supplying circuit 217 supplies electric power using the power supplying function, a power supplying unit need not be provided in each of the plurality of printed circuit boards 21A to 21C. Accordingly, the wiring of the battery system 500 can be further simplified, and the battery system 500 can be further reduced in size.

### [7] Seventh Embodiment

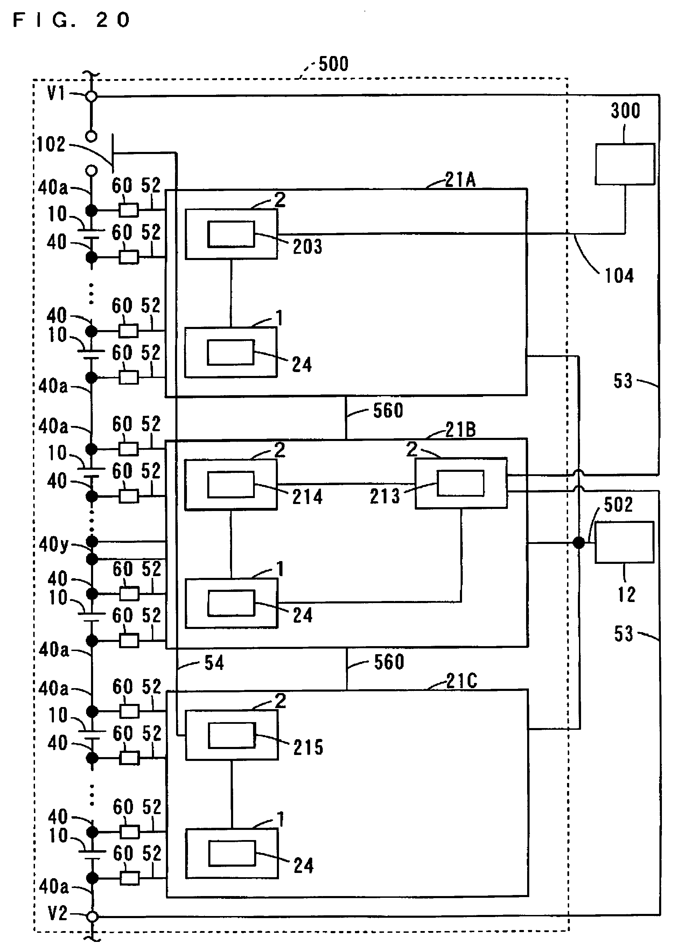

Description will be made of a battery system according to a seventh embodiment by referring to differences from the battery system 500 according to the second embodiment. Fig. 20 is a block diagram showing the configurations of printed circuit boards 21A to 21C in the seventh embodiment.

As shown in Fig. 20, as well as the cell characteristics detecting circuit 1, a control-related circuit 2 including a total voltage detecting circuit 213 and a control-related circuit 2 including an electric leakage detecting circuit 214 are mounted on the printed circuit board 21 B in the present embodiment. In addition, the control-related circuit 2 including the contactor controlling circuit 215 is mounted on the printed circuit board 21C.

The total voltage detecting circuit 213 is connected to the cell characteristics detecting circuit 1 of the printed circuit board 21 B while being connected to the electric leakage detecting circuit 214. The total voltage detecting circuit 213 is connected to the voltage terminals V1, V2 through the conductor lines 53. The electric leakage detecting circuit 214 is connected to the cell characteristics detecting circuit 1 of the printed circuit board 21 B while being connected to the total voltage detecting circuit 213. The contactor controlling circuit 215 is connected to the cell characteristics detecting circuit 1 of the printed circuit board 21C while being connected to the contactor 102.

The total voltage detecting circuit 213 detects a difference between voltage at the voltage terminal V1 and voltage at the voltage terminal V2 (a voltage difference between a plus electrode having the highest potential and a minus electrode having the lowest potential of the plurality of battery cells 10 connected in series; hereinafter referred to as total voltage). A value of the total voltage is applied to the electric leakage detecting circuit 214 while being applied to the main controller 300 through the serial communication circuits 24 of the cell characteristics detecting circuits 1 of the printed circuit boards 21A, 21B and the CAN communication circuit 203 of the printed circuit board 21A.

The electric leakage detecting circuit 214 detects the presence/absence of electric leakage in the plurality of battery cells 10 based on the detected value of the total voltage. An electric leakage detection signal indicating the presence/absence of electric leakage is applied from the electric leakage detecting circuit 214 to the contactor controlling circuit 215 through the serial communication circuits 24 of the cell characteristics detecting circuits 1 of the printed circuit boards 21B, 21C.

The contactor controlling circuit 215 controls the contactor 102 to be turned on and off based on the electric leakage detection signal from the electric leakage detecting circuit 214.

As described above, the control-related circuit 2 of the printed circuit board 21 B has a total voltage detecting function for detecting the total voltage of the plurality of battery cells 10 and an electric leakage detecting function for detecting the presence/absence of electric leakage in the plurality of battery cells 10 as functions of detecting a parameter of the plurality of battery cells 10 in the present embodiment. The control-related circuit 2 of the printed circuit board 21C has the contactor controlling function for controlling the contactor 102 to be turned on and off as the function of performing control related to the plurality of battery cells 10.

In this case, wiring among the cell characteristics detecting circuit 1, the total voltage detecting circuit 213 and the electric leakage detecting circuit 214 is formed on the printed circuit board 21B, and wiring between the cell characteristics detecting circuit 1 and the contactor controlling circuit 215 is formed on the printed circuit board 21C. Since the total voltage detecting circuit 213 detects the total voltage of the plurality of battery cells 10 using the total voltage detecting function, a detecting unit for detecting the total voltage need not be separately provided. Moreover, since the electric leakage detecting circuit 214 detects electric leakage in the plurality of battery cells 10 using the electric leakage detecting function, a detecting unit for detecting electric leakage need not be separately provided. Furthermore, since the contactor controlling circuit 215 controls the contactor 102 using the contactor controlling function, a controlling unit for controlling the contactor 102 need not be separately provided. Accordingly, the wiring of the battery system 500 can be further simplified, and the battery system 500 can be further reduced in size.

### [8] Eighth Embodiment

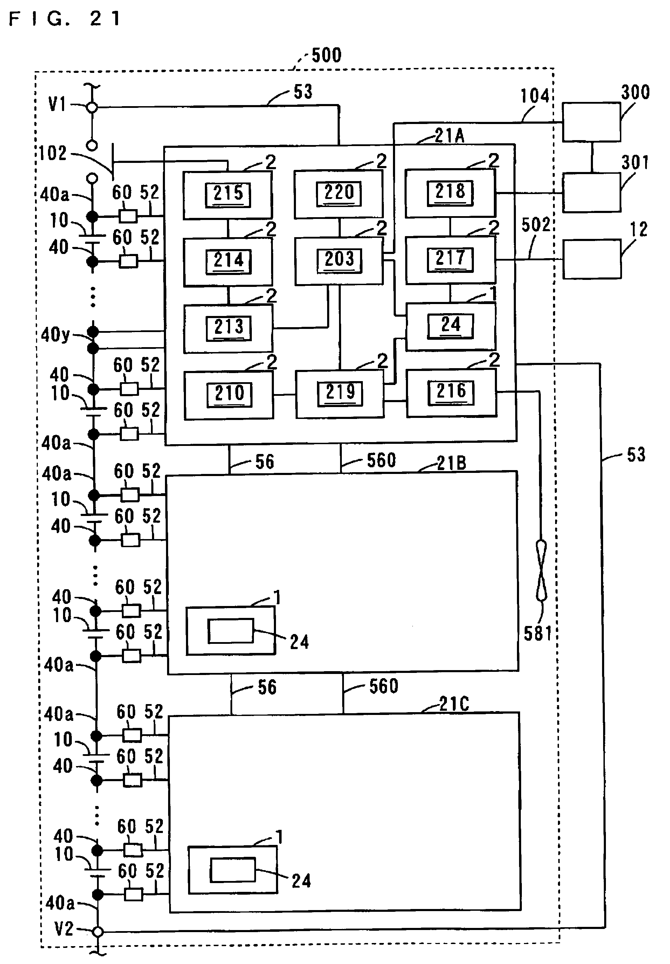

Description will be made of a battery system according to an eighth embodiment by referring to differences from the battery system 500 according to the second embodiment. Fig. 21 is a block diagram showing the configurations of printed circuit boards 21A to 21C in the eighth embodiment.

As shown in Fig. 21, as well as the cell characteristics detecting circuit 1, the control-related circuit 2 including the current detecting circuit 210, the control-related circuit 2 including the total voltage detecting circuit 213, the control-related circuit 2 including the electric leakage detecting circuit 214, the control-related circuit 2 including the contactor controlling circuit 215, the control-related circuit 2 including the fan controlling circuit 216, the control-related circuit 2 including the power supplying circuit 217, the control-related circuit 2 including the vehicle start-up detecting circuit 218, the control-related circuit 2 including the operating circuit 219 and the control-related circuit 2 including the watchdog circuit 220 are mounted on the printed circuit board 21A in the present embodiment.

The battery system 500 according to the present embodiment further includes the fan 581 for releasing heat from the battery modules 100. The voltage/current bus bar 40y of Fig. 17 instead of one of the plurality of bus bars 40 is provided in the battery system 500 according to the present embodiment. The electric vehicle includes the start-up signal generator 301 that generates the start-up signal at the time of start-up.

The current detecting circuit 210 is connected to the operating circuit 219 while being connected to the voltage/current bus bar 40y. The operating circuit 219 is connected to the cell characteristics detecting circuit 1 of the printed circuit board 21A while being connected to the CAN communication circuit 203 and the fan controlling circuit 216.

The current detecting circuit 210 detects the current flowing through the plurality of battery cells 10 in the form of voltage, and applies the voltage to the operating circuit 219. The operating circuit 219 calculates a value of the current based on a value of the voltage from the current detecting circuit 210. The operating circuit 219 calculates the charged capacity of each battery cell 10 from the cell information. Here, when detecting that a charged capacity of one battery cell 10 is larger than each of charged capacities of the other battery cells 10, the operating circuit 219 turns on the switching element SW (see Fig. 3) connected to the battery cell 10 having the larger charged capacity through the serial communication circuits 24 of the printed circuit boards 21A to 21C.

Thus, charges stored in the battery cell 10 are discharged through the resistor R (see Fig. 3). When the charged capacity of the battery cell 10 decreases to be substantially equal to each of the charged capacities of the other battery cells 10, the operating circuit 219 turns off the switching element SW connected to the battery cell 10. ln this manner, charged capacities of all the battery cells 10 are kept substantially equal.

The fan controlling circuit 216 is connected to the operating circuit 219 while being connected to the fan 581. The operating circuit 219 applies the cell information of the plurality of battery modules 100 to the fan controlling circuit 216. The fan controlling circuit 216 controls the fan 581 to be switched on and off and controls the rotational speed of the fan 581 based on the cell information of the battery modules 100.

The total voltage detecting circuit 213 is connected to the CAN communication circuit 203 while being connected to the electric leakage detecting circuit 214. The total voltage detecting circuit 213 is connected to the voltage terminals V1, V2 through the conductor lines 53. The electric leakage detecting circuit 214 is connected to the total voltage detecting circuit 213 while being connected to the contactor controlling circuit 215. The contactor controlling circuit 215 is connected to the electric leakage detecting circuit 214 while being connected to the contactor 102.

The total voltage detecting circuit 213 detects the total voltage of the plurality of battery cells 10. The value of the total voltage is applied to the electric leakage detecting circuit 214 while being applied to the main controller 300 through the CAN communication circuit 203.

The electric leakage detecting circuit 214 detects the presence/absence of electric leakage in the plurality of battery cells 10 based on the detected value of the total voltage. The electric leakage detection signal indicating the presence/absence of electric leakage is applied from the electric leakage detecting circuit 214 to the contactor controlling circuit 215.

The contactor controlling circuit 215 controls the contactor 102 to be turned on and off based on the electric leakage detection signal from the electric leakage detecting circuit 214.

The power supplying circuit 217 is connected to the cell characteristics detecting circuit 1 of the printed circuit board 21A while being connected to the non-driving battery 12 through the power supply line 502. The power supplying circuit 217 is connected to the printed circuit boards 21B, 21C through the conductor lines 56. The power supplying circuit 217 includes the DC-DC converter, and converts the voltage from the non-driving battery 12 into the low voltage.

The vehicle start-up detecting circuit 218 is connected to the power supplying circuit 217 of the printed circuit board 21A while being connected to the start-up signal generator 301. The start-up signal generator 301 is also connected to the main controller 300.

The vehicle start-up detecting circuit 218 detects the start-up signal generated by the start-up signal generator 301. When detecting the start-up signal, the vehicle start-up detecting circuit 218 starts up the power supplying circuit 217. The started power supplying circuit 217 applies the low voltage obtained by the DC-DC converter to the cell characteristics detecting circuits 1 of the plurality of printed circuit boards 21A to 21C as the power source. This causes the cell characteristics detecting circuits 1 of the plurality of printed circuit boards 21A to 21C to be started.

The cell characteristics detecting circuits 1 of the printed circuit boards 21A to 21C are started, thereby starting the serial communication circuits 24. This allows for the serial communication among the printed circuit boards 21A to 21C.

The watchdog circuit 220 is connected to the CAN communication circuit 203 while being connected to the contactor 102. The watchdog circuit 220 monitors the presence/absence of abnormality of the CPU included in the CAN communication circuit 203, for example. When the CPU is normally operated, the signal of the cycle is sent from the CPU to the watchdog circuit 220. Meanwhile, when abnormality occurs in the CPU, the signal is not sent to the watchdog circuit 220. In this case, the watchdog circuit 220 controls the CPU to restart. This causes the CPU to recover from the abnormality.

As described above, the control-related circuit 2 of the printed circuit board 21A has the current detecting function for detecting the current flowing through the plurality of battery cells 10 in the form of voltage, the total voltage detecting function for detecting the total voltage of the plurality of battery cells 10 and the electric leakage detecting function for detecting the presence/absence of electric leakage in the plurality of battery cells 10 as the functions of detecting a parameter of the plurality of battery cells 10 in the present embodiment.

The control-related circuits 2 of the printed circuit board 21A has the CAN communication function for performing the CAN communication with the main controller 300 of the electric vehicle, the contactor controlling function for controlling the contactor 102 to be turned on and off, the fan controlling function for controlling the fan 581, the start-up controlling function for controlling the serial communication circuits 24 of the cell characteristics detecting circuits 1 to start up in response to start-up of the electric vehicle, the operating function for calculating the value of the current flowing through the plurality of battery cells 10 and calculating the charged capacity of each battery cell 10, and the equalization control function for equalizing the charged capacities of the plurality of battery cells 10, and the watchdog function for controlling the CPU of the CAN communication circuit 203 to restart.

The control-related circuit 2 of the printed circuit board 21A has the power supplying function for supplying electric power to the cell characteristics detecting circuits 1 of the plurality of printed circuit boards 21A to 21C as the function of supplying electric power to the plurality of printed circuit boards 21A to 21C.

ln this case, the wiring among the cell characteristics detecting circuit 1 and the plurality of control-related circuits 2 is formed on the printed circuit board 21A.

A detecting unit for detecting the current, a detecting unit for detecting the total voltage, and a detecting unit for detecting electric leakage need not be separately provided.

A controlling unit having the CAN communication function, a controlling unit for controlling the contactor 102, a controlling unit for controlling the fan 581, and a controlling unit for controlling the serial communication circuit 24 to start up need not be separately provided.

An operating unit for calculating the value of the current and the charged capacity, a controlling unit for performing the equalization control of the charged capacities and a controlling unit for controlling the CPU need not be separately provided.

A power supplying unit need not be provided in each of the plurality of printed circuit boards 21A to 21C.

Accordingly, the wiring of the battery system 500 can be further simplified, and the battery system 500 can be further reduced in size.

### [9] Ninth Embodiment

Description will be made of a battery system according to a ninth embodiment by referring to differences from the battery system 500 according to the first embodiment.

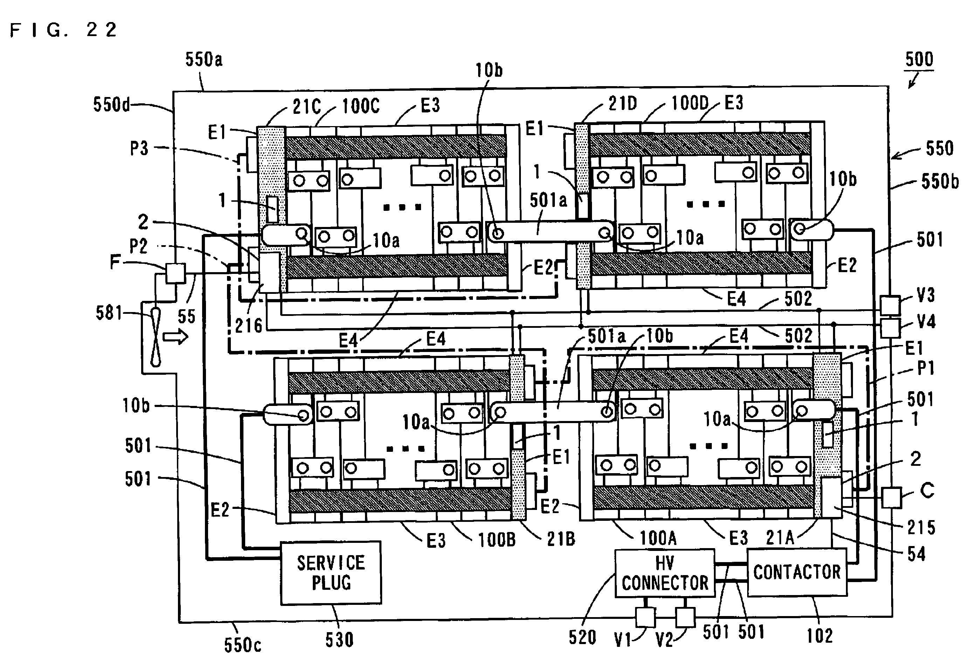

Fig. 22 is a schematic plan view showing one example of connection and wiring among battery modules 100A to 100D in the battery system 500 according to the ninth embodiment. The battery system 500 according to the present embodiment includes the battery modules 100A to 100D, the printed circuit boards 21A to 21 D, the contactor 102, an HV (High Voltage) connector 520, a service plug 530 and the fan 581.

As shown in Fig. 22, the end surface E2 of the battery module 100C and the end surface E1 of the battery module 100D are arranged to face each other, and the end surface E1 of the battery module 100B and the end surface E2 of the battery module 100A are arranged to face each other in the present embodiment. The side surface E4 of the battery module 100C and the side surface E4 of the battery module 100B are arranged to face each other, and the side surface E4 of the battery module 100D and the side surface E4 of the battery module 100A are arranged to face each other. The end surface E1 of the battery module 100C and the end surface E2 of the battery module 100B are arranged to be directed to the side wall 550d, and the end surface E2 of the battery module 100D and the end surface E1 of the battery module 100A are arranged to be directed to the side wall 550b.

The service plug 530, the HV connector 520 and the contactor 102 are arranged to line up in this order from the side wall 550d toward the side wall 550b in a region between the side surfaces E3 of the battery modules 100A, 100B and the side wall 550c. The HV connector 520 includes the voltage terminals V1, V2. The voltage terminals V3, V4 and the communication terminal C are provided on the side wall 550b of the casing 550. The voltage terminals V1, V2 of the HV connector 520 are provided on the side wall 550c. The fan terminal F is provided on the side wall 550d. Connection and wiring among the communication terminal C and the voltage terminals V3, V4 are the same as those in the first embodiment.

The printed circuit boards 21A to 21D are provided corresponding to the battery modules 100A to 100D, respectively. The printed circuit boards 21A to 21D each have the cell characteristics detecting circuit 1 having the cell characteristics detecting function for detecting the cell characteristics of the plurality of battery cells 10 of the respective corresponding battery modules 100A to 100D mounted thereon. As well as the cell characteristics detecting circuit 1, the control-related circuit 2 having a function different from the cell characteristics detecting function for each battery cell 10 is mounted on each of the printed circuit boards 21A, 21C. The control-related circuit 2 of the printed circuit board 21A includes the CAN communication circuit 203 and the contactor controlling circuit 215. The control-related circuit 2 of the printed circuit board 21C includes the fan controlling circuit 216. The CAN communication circuit 203 of the printed circuit board 21A is not shown.

The minus electrode 10b having the lowest potential in the battery module 100A and the plus electrode 10a having the highest potential in the battery module 100B are connected through the bus bar 501a. The minus electrode 10b having the lowest potential in the battery module 100C and the plus electrode 10a having the highest potential in the battery module 100D are connected through the bus bar 501a. The minus electrode 10b having the lowest potential in the battery module 100B is connected to the service plug 530 through the power supply line 501, and the plus electrode 10a having the highest potential in the battery module 100C is connected to the service plug 530 through the power supply line 501.

The service plug 530 is turned off by a worker during maintenance of the battery system 500, for example. When the service plug 530 is turned off, the series circuit composed of the battery modules 100A, 100B and the series circuit composed of the battery modules 100C, 100D are electrically separated from each other. In this case, the current path among the four battery modules 100A to 100D is cut off. This provides a high degree of safety during maintenance.

The contactor 102 as well as the service plug 530 are turned off by a worker during maintenance of the battery system 500. In this case, the current path among the four battery modules 100A to 100D is reliably cut off. This sufficiently provides a high degree of safety during maintenance. When the battery modules 100A to 100D have equal voltages, the total voltage of the series circuit composed of the battery modules 100A, 100B is equal to the total voltage of the series circuit composed of the battery modules 100C, 100D. This prevents a high voltage from being generated in the battery system 500 during maintenance.

The plus electrode 10a having the highest potential in the battery module 100A is connected to the voltage terminal V1 of the HV connector 520 through the power supply line 501 via the contactor 102. The minus electrode 10b having the lowest potential in the battery module 100D is connected to the voltage terminal V2 of the HV connector 520 through the power supply line 501 via the contactor 102. ln this case, the motor or the like of the electric vehicle is connected between the voltage terminals V1, V2, so that electric power generated in the battery modules 100A to 100D connected in series can be supplied to the motor or the like.

The serial communication circuit 24 (see Fig. 2) of the cell characteristics detecting circuit 1 of the printed circuit board 21A and the serial communication circuit 24 of the cell characteristics detecting circuit 1 of the printed circuit board 21 B are connected to each other through a communication line P1. The serial communication circuit 24 of the cell characteristics detecting circuit 1 of the printed circuit board 21 B and the serial communication circuit 24 of the cell characteristics detecting circuit 1 of the printed circuit board 21C are connected to each other through a communication line P2. The serial communication circuit 24 of the cell characteristics detecting circuit 1 of the printed circuit board 21 C and the serial communication circuit 24 of the cell characteristics detecting circuit 1 of the printed circuit board 21 D are connected to each other through a communication line P3. The communication lines P1 to P3 constitute a bus.

The printed circuit board 21A is arranged in the vicinity of the communication terminal C and the contactor 102 in the present embodiment. The CAN communication circuit 203 of the printed circuit board 21A is connected to the communication terminal C through a conductor line. This allows for communication between the control-related circuit 2 and the main controller 300. The contactor controlling circuit 215 of the printed circuit board 21A is connected to the contactor 102 through a conductor line 54. Thus, the control-related circuit 2 can control the contactor 102 to be turned on and off.

The printed circuit board 21 C is arranged in the vicinity of the fan terminal F. The fan 581 is connected to the fan terminal F. The fan controlling circuit 216 of the printed circuit board 21C is connected to the fan terminal F through a conductor line 55. Accordingly, the control-related circuit 2 can control the fan 581 to be turned on and off or control the rotational speed of the fan 581.

As described above, the printed circuit board 21A includes the control-related circuit 2, and the control-related circuit 2 includes the CAN communication circuit 203 and the contactor controlling circuit 215 in the battery system 500 according to the present embodiment. This allows for communication between the serial communication circuits 24 of the battery modules 100A to 100D and the main controller 300 of the electric vehicle via the CAN communication circuit 203. Moreover, the contactor 102 is controlled to be turned on and off.

The printed circuit board 21C includes the control-related circuit 2, and the control-related circuit 2 includes the fan controlling circuit 216. Thus, the fan 581 is controlled to be turned on and off, or the rotational speed of the fan 581 is controlled.

Accordingly, a fan controlling unit, a CAN communication unit and a contactor controlling unit need not be separately provided in the battery system 500. This allows wiring of the battery system 500 to be simplified and allows the battery system 500 to be reduced in size. The main controller 300 may not have the fan controlling function and the contactor controlling function, thus reducing burdens on the processing of the main controller 300.

The printed circuit board 21A is arranged in the vicinity of the communication terminal C and the contactor 102. That is, the printed circuit board 21A including the CAN communication circuit 203 and the contactor controlling circuit 215 is arranged closer to the communication terminal C and the contactor 102 than the other printed circuit boards 21 B to 21 D. This shortens the wiring connecting the control-related circuit 2 and the communication terminal C and the wiring (conductor line 54) connecting the control-related circuit 2 and the contactor 102.

The printed circuit board 21 C is arranged in the vicinity of the fan terminal F. That is, the printed circuit board 21C including the fan controlling circuit 216 is arranged closer to the fan terminal F than the other printed circuit boards 21A, 21 B, 21 D. This shortens the wiring (conductor line 55) connecting the control-related circuit 2 and the fan terminal F.

### [10] Tenth Embodiment

Description will be made of an electric vehicle according to a tenth embodiment. The electric vehicle according to the present embodiment includes the battery system according to any of the first to ninth embodiments. In the following paragraphs, an electric automobile is described as one example of the electric vehicle.

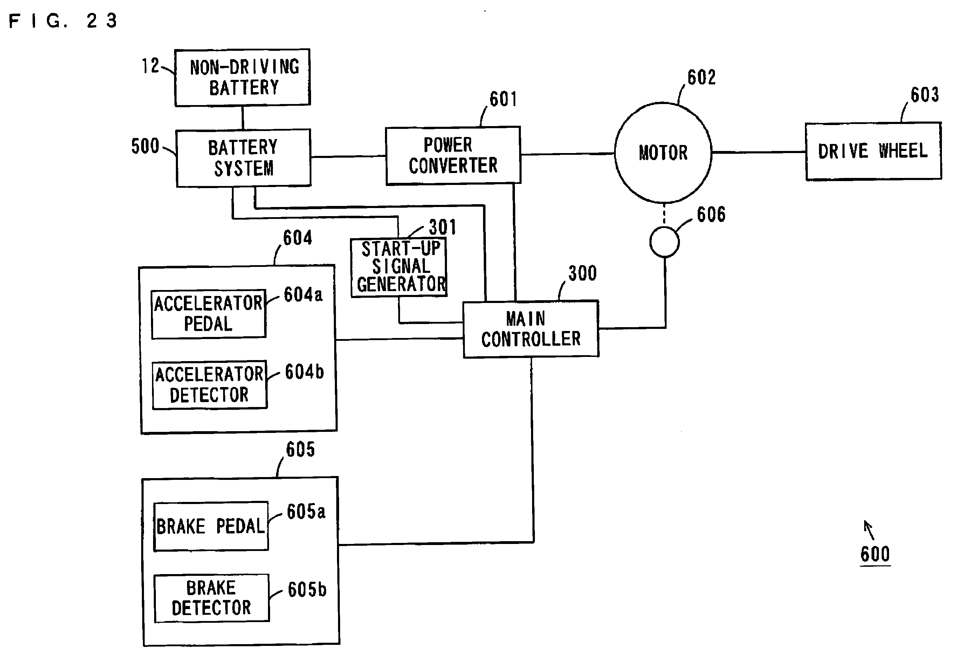

Fig. 23 is a block diagram showing the configuration of the electric automobile including the battery system 500. As shown in Fig. 23, the electric automobile 600 according to the present embodiment includes the battery system 500, the main controller 300, the non-driving battery 12, the start-up signal generator 301, a power converter 601, a motor 602, drive wheels 603, an accelerator system 604, a brake system 605, and a rotational speed sensor 606. When the motor 602 is an alternating current (AC) motor, the power converter 601 includes an inverter circuit.

As described above, the non-driving battery 12 and the start-up signal generator 301 are connected to the battery system 500 in the present embodiment. The battery system 500 is connected to the motor 602 via the power converter 601 while being connected to the main controller 300. The cell information of the plurality of battery modules 100 (see Fig. 1) is applied from the CAN communication circuit 203 (see Fig. 2) of the printed circuit board 21A of the battery system 500 to the main controller 300. Each of the start-up signal generator 301, the accelerator system 604, the brake system 605 and the rotational speed sensor 606 is connected to the main controller 300. The main controller 300 is composed of a CPU and a memory or composed of a microcomputer, for example.

The accelerator system 604 includes an accelerator pedal 604a included in the electric automobile 600 and an accelerator detector 604b that detects an operation amount (depression amount) of the accelerator pedal 604a. When the accelerator pedal 604a is operated by a driver, the accelerator detector 604b detects the operation amount of the accelerator pedal 604a. Note that a state of the accelerator pedal 604a when not being operated by the driver is set as a reference. The detected operation amount of the accelerator pedal 604a is applied to the main controller 300.

The start-up signal generator 301 generates the start-up signal at the time of start-up of the electric automobile 600. The start-up signal is applied to the battery system 500 and the main controller 300.

The brake system 605 includes a brake pedal 605a provided in the electric automobile 600 and a brake detector 605b that detects an operation amount (depression amount) of the brake pedal 605a by the driver. When the brake pedal 605a is operated by the driver, the operation amount is detected by the brake detector 605b. The detected operation amount of the brake pedal 605a is applied to the main controller 300.

The rotational speed sensor 606 detects a rotational speed of the motor 602. The detected rotational speed is applied to the main controller 300.

The main controller 300 is started when detecting the start-up signal from the start-up signal generator 301. As described in the foregoing, the cell information of the battery modules 100, the operation amount of the accelerator pedal 604a, the operation amount of the brake pedal 605a and the rotational speed of the motor 602 are applied to the main controller 300. The main controller 300 performs charge/discharge control of the battery modules 100 and power conversion control by the power converter 601 based on the information.

Electric power generated by the battery modules 100 is supplied from the battery system 500 to the power converter 601 at the time of start-up and acceleration of the electric automobile 600 based on the accelerator operation, for example.

Furthermore, the main controller 300 calculates a torque (commanded torque) to be transmitted to the drive wheels 603 based on the applied operation amount of the accelerator pedal 604a, and applies a control signal based on the commanded torque to the power converter 601.

The power converter 601 receives the control signal, and then converts the electric power supplied from the battery system 500 into electric power (driving power) required for driving the drive wheels 603. Accordingly, the driving power converted by the power converter 601 is supplied to the motor 602, and the torque of the motor 602 based on the driving power is transmitted to the drive wheels 603.

Meanwhile, the motor 602 functions as a power generation system at the time of deceleration of the electric automobile 600 based on the brake operation. In this case, the power converter 601 converts regenerated electric power generated by the motor 602 to electric power suitable for charging the battery modules 100, and supplies the electric power to the battery modules 100. This causes the battery modules 100 to be charged.

As described above, the electric automobile 600 according to the present embodiment is provided with the battery system according to any of the first to ninth embodiments. Thus, the wiring in the electric automobile 600 can be simplified, and the electric automobile 600 can be reduced in size.

### [11] Other Embodiments

(1) While the battery systems 500 according to the first and ninth embodiments each include the four battery modules 100 and the four printed circuit boards 21A to 21 D, and the battery systems 500 according to the second to eighth embodiments each include the four battery modules 100 and the three printed circuit boards 21A to 21C, the present invention is not limited to this.
   The battery system 500 may include three or less battery modules 100, or may include five or more battery modules 100. The battery system 500 may include two or less printed circuit boards, or may include five or more printed circuit boards. When the battery module 100 includes a large number of battery cells 10, the battery system 500 may include a larger number of printed circuit boards than the number of the battery modules 100.
(2) While three or less functions of the CAN communication function, the fan controlling function, the current detecting function, the operating function, the equalization controlling function, the watchdog function, the start-up controlling function, the power supplying function, the total voltage detecting function, the electric leakage detecting function and the contactor controlling function (hereinafter referred to as the control-related functions) are mounted on one printed circuit board in the battery systems 500 according to the first to seventh and ninth embodiments, the present invention is not limited to this. Four or more control-related functions may be mounted on one printed circuit board.
(3) While all the control-related functions are mounted on one printed circuit board in the battery system 500 according to the eighth embodiment, the present invention is not limited to this. The plurality of control-related functions may be distributed among the plurality of printed circuit boards to be mounted.
(4) While the current flowing through the plurality of battery cells 10 is detected in the form of voltage by the current detecting function and the value of the current is calculated by the operating function based on the value of the voltage detected by the current detecting function in the battery system 500 according to the fourth embodiment, the present invention is not limited to this.
   When the battery system 500 does not have the current detecting function, the main controller 300 of the electric vehicle may detect the current flowing through the plurality of battery cells 10 in the form of voltage, and the value of the current may be calculated by the operating function based on the value of the voltage detected by the main controller 300 of the electric vehicle.
   Similarly, when the battery system 500 does not have the operating function, the current flowing through the plurality of battery cells 10 may be detected in the form of voltage by the current detecting function, and the main controller 300 of the electric vehicle may calculate the value of the current based on the value of the voltage detected by the current detecting function.
(5) While the presence/absence of abnormality of the CPU of the CAN communication circuit 203 is monitored by the watchdog function in the battery system 500 according to the fifth embodiment, the present invention is not limited to this. The presence/absence of abnormality of the CPU included in the serial communication circuit 24, the operating circuit 219, the main controller 300 of the electric vehicle or the like, for example, may be monitored by the watchdog function.
(6) While the total voltage of the plurality of battery cells 10 is detected by the total voltage detecting function, the presence/absence of electric leakage in the plurality of battery cells 10 is detected by the electric leakage detecting function based on the value of the total voltage detected by the total voltage detecting function, and the contactor 102 is controlled by the contactor controlling function based on the electric leakage detection signal generated by the electric leakage detecting function in the battery system 500 according to the seventh embodiment, the present invention is not limited to this.
   When the battery system 500 does not have at least one of the total voltage detecting function and the electric leakage detecting function, the main controller 300 of the electric vehicle may detect the total voltage of the plurality of battery cells 10 and detect the presence/absence of electric leakage in the plurality of battery cells 10 based on the value of the total voltage, and the contactor 102 may be controlled by the contactor controlling function based on the electric leakage detection signal generated by the main controller 300 of the electric vehicle.
   Similarly, when the battery system 500 does not have at least one of the electric leakage detecting function and the contactor controlling function, the total voltage of the plurality of battery cells 10 may be detected by the total voltage detecting function, and the main controller 300 of the electric vehicle may detect the presence/absence of electric leakage in the plurality of battery cells 10 based on the value of the total voltage detected by the total voltage detecting function and control the contactor 102 based on the electric leakage detection signal.
   When the battery system 500 does not have at least one of the total voltage detecting function and the contactor controlling function, the main controller 300 of the electric vehicle may detect the total voltage of the plurality of battery cells 10, the presence/absence of electric leakage in the plurality of battery cells 10 may be detected by the electric leakage detecting function based on the value of the total voltage detected by the main controller 300 of the electric vehicle, and the main controller 300 of the electric vehicle may control the contactor 102 based on the electric leakage detection signal generated by the electric leakage detecting function.
(7) While the battery cell 10 has a substantially rectangular parallelepiped shape in the first to ninth embodiments, the present invention is not limited to this. The battery cell 10 may have a cylindrical shape.
(8) In the second embodiment, the cell characteristics detecting circuit 1 of each of the printed circuit boards 21A, 21 B detects the cell characteristics of the plurality of (eighteen in the example of the second embodiment) battery cells 10 of the corresponding battery module 100. The cell characteristics detecting circuit 1 of the printed circuit board 21 C detects the cell characteristics of the plurality of (thirty-six in the example of the second embodiment) battery cells 10 of the corresponding battery module 100 and another battery module 100 arranged next thereto.
In this manner, the cell characteristics detecting circuit 1 of the printed circuit board 21 C detects the cell characteristics of the larger number of the battery cells 10 than the cell characteristics detecting circuits 1 of the printed circuit boards 21A, 21B. Therefore, in the case where the cell characteristics detecting circuit 1 of the printed circuit board 21C is made larger than each of the cell characteristics detecting circuits 1 of the printed circuit boards 21A, 21 B, the control-related circuit 2 is preferably mounted on the printed circuit boards 21A, 21 B (the printed circuit board 21A in the example of the second embodiment). In this case, the printed circuit board 21C can be prevented from being increased in size. In addition, increased power consumption in the printed circuit board 21C can be suppressed.

### [12] Correspondences between Elements in the Claims and Parts in Embodiments

ln the following paragraphs, non-limiting examples of correspondences between various elements recited in the claims below and those described above with respect to various preferred embodiments of the present invention are explained.

In the above-described embodiments, the battery cel1 10 is an example of a battery cell, the printed circuit boards 21A to 21 D are examples of a circuit board, the voltage and temperature (cell characteristics) of the plurality of battery cells 10 are examples of a first parameter, and the cell characteristics detecting function is an example of a first function.

The CAN communication function, the fan controlling function, the current detecting function, the operating function, the equalization controlling function, the watchdog function, the start-up controlling function, the power supplying function, the total voltage detecting function, the electric leakage detecting function or the contactor controlling function (the control-related function) is an example of a second function.

The current flowing through the plurality of battery cells 10, the total voltage of the plurality of battery cells 10 or electric leakage in the plurality of battery cells 10 is an example of a second parameter, and the current detecting function, the total voltage detecting function or the electric leakage detecting function is an example of a function of detecting the second parameter. The CAN communication function, the fan controlling function, the operating function, the equalization controlling function, the watchdog function, the start-up controlling function or the contactor controlling function is an example of a function of performing control related to the battery cell, and the power supplying function is an example of a function of supplying electric power to a portion of the circuit board. The series circuit composed of the resistor R and the switching element SW is an example of a discharging circuit, the battery system 500 is an example of a battery system, the motor 602 is an example of a motor, each of the drive wheels 603 is an example of a drive wheel, and the electric automobile 600 is an example of an electric vehicle.

As each of various elements recited in the claims, various other elements having configurations or functions described in the claims can be also used.

While preferred embodiments of the present invention have been described above, it is to be understood that variations and modifications will be apparent to those skilled in the art without departing the scope and spirit of the present invention. The scope of the present invention, therefore, is to be determined solely by the following claims as interpreted by the description and drawings.

## Claims

1. A battery system comprising:
a plurality of battery cells; and
one or a plurality of circuit boards; wherein
each of said one or plurality of circuit boards has a first function of detecting a first parameter of each battery cell, and
at least one circuit board further has a second function that is different from said first function.

2. The battery system according to claim 1, wherein said second function includes a function of detecting a second parameter of each of said plurality of battery cells.

3. The battery system according to claim 1, wherein said second function includes a function of performing control related to said plurality of battery cells.

4. The battery system according to claim 1, wherein said second function includes a function of supplying electric power to a portion, which implements said first function, of said one or plurality of circuit boards.

5. The battery system according to claim 1, wherein each of said plurality of circuit boards further includes a discharging circuit arranged to cause each battery cell to discharge.

6. An electric vehicle comprising:
the battery system according to claim 1;
a motor driven by electric power supplied from said plurality of battery cells of said battery system; and
a drive wheel rotated by a torque generated by said motor.
